Europäisches Patentamt

European Patent Office

Office européen des brevets

(19)

(11) **EP 1 058 966 B1**

(12) **EUROPÄISCHE PATENTSCHRIFT**

(45) Veröffentlichungstag und Bekanntmachung des Hinweises auf die Patenterteilung:
**16.01.2002 Patentblatt 2002/03**

(21) Anmeldenummer: **99910303.9**

(22) Anmeldetag: **27.02.1999**

(51) Int Cl.⁷: **H03K 11/00**

(86) Internationale Anmeldenummer:
**PCT/EP99/01297**

(87) Internationale Veröffentlichungsnummer:
**WO 99/45648 (10.09.1999 Gazette 1999/36)**

(54) **VERFAHREN ZUR QUANTISIERUNG VON BINÄRSIGNALEN**

METHOD FOR QUANTIZING BINARY SIGNALS

PROCEDE DE QUANTIFICATION DE SIGNAUX BINAIRES

(84) Benannte Vertragsstaaten:
**DE FI FR GB NL**

(30) Priorität: **03.03.1998 DE 19808874**

(43) Veröffentlichungstag der Anmeldung:
**13.12.2000 Patentblatt 2000/50**

(73) Patentinhaber: **Vonhoerner & Sulger GmbH**
**68723 Schwetzingen (DE)**

(72) Erfinder: **HENKEL, Hartmut**
**D-68723 Oftersheim (DE)**

(74) Vertreter: **Mierswa, Klaus**
**Rechtsanwalt, Friedrichstr. 171**
**68199 Mannheim (DE)**

(56) Entgegenhaltungen:
| | |
|---|---|
| **EP-A- 0 517 533** | **US-A- 3 989 961** |
| **US-A- 5 245 557** | **US-A- 5 448 202** |

EP 1 058 966 B1

**Beschreibung**

Technisches Gebiet:

Die Erfindung betrifft ein Verfahren zur Quantisierung von Binärsignalen, bestehend aus einer digitalen Speicher- und Logikschaltung, einer analogen Filter- und Summierschaltung erster oder höherer Ordnung mit einem oder mehreren Eingängen, einer oder mehreren gesteuerten Quellen für je eine elektrische Größe mit zwei möglichen Werten, die von Quelle zu Quelle verschieden sein können, einem Komparator mit gegebener Schaltschwelle, mit analogem Eingang und Logikausgang, sowie einem Taktgenerator mit gegebener Frequenz.

Problemstellung:

Verfahren zur Quantisierung von Binärsignalen werden in vielen Technikbereichen benötigt—vor allem dort, wo Binärsignale Informationen enthalten, die digital weiterverarbeitet werden sollen.

Eine typische Anwendung in der Kommunikationstechnik betrifft den Empfang frequenz- bzw. phasenmodulierter Träger. Häufig ist bei der Demodulation solcher Signale das Ergebnis in digitaler Form gewünscht, z. B., um es digital weiterzuverarbeiten. In modernen digitalen Empfängerschaltungen wird der Spannungsverlauf des analogen. Antennensignals (oder des Zwischenfrequenzsignals) mit schnellen Analog/Digital-Umsetzern (ADU) in einen Datenstrom mit einer Wortbreite von mehreren Bit (z. B. 8) umgesetzt (d. h. nicht in ein Binärsignal), und die Frequenz- bzw. Phasendemodulation erfolgt mit Hilfe digitaler Signalverarbeitung (siehe die Literaturstellen Behzad Razavi: Challenges in Portable RF Transceiver Design, IEEE Circuits Syst. Magazine, 12:12-25, September 1996; Okunev, Yuri: Phase and Phase-Difference Modulation in Digital Communications, Artech House, Boston, 1. Auflage, 1997). Solche Konzepte benötigen schnelle und damit teure ADUs, sowie eine aufwendige Signalverarbeitung bei hoher Geschwindigkeit. Daher haben sie generell auch einen hohen Leistungsbedarf.

Alternativ kann man jedoch das empfangene frequenz- bzw. phasenmodulierte Signal z.B. durch Begrenzung in ein Binärsignal umsetzen, und dieses weiterverarbeiten. Im Binärsignal ist die Information nicht mehr im Wertebereich der Signalspannung oder des Signalstroms enthalten, sondern in den zeitlichen Positionen der Signalflanken. Es ergibt sich nun das Problem, zur digitalen Weiterverarbeitung diese Flanken ohne signifikanten Informationsverlust in ein gegebenes digitales Taktraster zu bringen, d. h. das Binärsignal zeitlich zu quantisieren. Der Takt kann hierbei z. B. von einern Quarzoszillator geliefert werden.

Hat der Oszillator eine höhere Frequenz als das Binärsignal, so kann man dieses z.B. dem D-Eingang eines vom Oszillator getakteten D-Flipflops zuführen, wodurch das Binärsignal in einen Ein-Bit-Datenstrom im Taktraster des Oszillators umgesetzt und somit zeitlich quantisiert wird. Der Nachteil dieses rein digitalen Verfahrens ist, daß wegen des im allg. unbekannten Zeitbezugs zwischen den Flanken des Binärsignals und dem Abtasttakt sich bei jeder Flanke ein unbekannter Zeitfehler addiert, der im Datenstrom auch nicht mehr korrigiert werden kann.

Zur Reduktion dieses Zeitfehlers bei der Quantisierung von Binärsignalen gibt es mehrere Verfahren, die jeweils typische Nachteile aufweisen.

Beispielsweise kann man bei der geschilderten zeitlichen Quantisierung mit einem D-Flipflop durch Erhöhen der Abtastfrequenz den maximalen Zeitfehler reduzieren. Die Abtastfrequenz ist jedoch nach oben durch die Geschwindigkeit und den Stromverbrauch der verwendeten Komponenten begrenzt.

Verfahren zur Quantisierung von Binärsignalen, welche den Zeitfehler bei jeder Abtastung zeit-analog bestimmen und entsprechend in Rechnung stellen, haben gegenüber dem genannten rein digitalen Verfahren den Vorteil einer höheren zeitlichen Auflösung, bzw, eines geringeren Phasen-Quantisierungsfehlers. Hierzu zählen z. B. sogenannte Phasenregelschleifen, auch PLL, Phase-Locked Loop genannt, (siehe die Literaturstelle Roland E. Best: Phase-locked loops: Theory, Design, and Applications, McGraw-Hill, Inc., 1. Auflage, 1993) sofern sie einen zeit-analogen Phasenvergleicher aufweisen. Daher fallen voll-digitale Phasenregelschleifen (ADPLL, All-Digital Phase-Locked Loop, siehe die Literaturstelle Best) mit zeit-digitalem Phasenvergleicher aus der Betrachtung heraus, denn es entstehen bei diesen prinzipiell die gleichen Quantisierungsfehler wie bei der zeitlichen Quantisierung mit einem D-Flipflop.

Teil-digitale PLLs besitzen einen zeit-analogen Phasenvergleicher, ein analoges Schleifenfilter (z.B. Tiefpaß), und einen analog steuerbaren Oszillator (z.B. VCO, Voltage Controlled Oscillator). Diese PLLs selbst quantisierten jedoch das ankommende Binärsignal nicht, d. h. liefern auch keinen synchronen Ein-Bit-Datenstrom. Erweitert man die PLL um einen dem Ausgang des PLL-Schleifenfilters nachgeschalteten Analog/Digital-Umsetzer (ADU), so liefert dieser z. B. die quantisierte Momentanfrequenz des Binärsignals als digitalen Datenstrom mit einer durch den ADU gegebenen Wortbreite. D.h., die Quantisierung des Binärsignals erfolgt über seine Demodulation. Der Quantisierungsfehler ist hierbei durch die PLL-Komponenten und den ADU begrenzt, die alle weitgehend analog aufgebaut und damit rausch- und driftbehaftet sind.

Stand der Technik:

Durch die US 5,448,202 A1 ist ein zeitanaloger $\Sigma\triangle$-FM-Demodulator bekannt geworden, mit dem Nachteil, daß der vom Demodulator gelieferte Bitstrom synchron zu einem nicht-gleichmäßigen Bit-Takt (Frequenz des Binärsignals) ist. Daher eignet sich dieser Bitstrom schlecht zur weiteren digitalen Verarbeitung in einer synchronen Taktumgebung. Weiterhin liefert der Demodulator trotz hohem Schaltungsaufwand im allg. nur eine Ein-Bit-Information je ausgewertete Flanke des Binärsignals.

Durch die Literaturstelle R. Douglas Beards, Miles A. Copeland: An Oversampling Delta-Sigma Frequency Discriminator, IEEE Trans. Circuits Syst. II, 41:26-32, January 1994, wird aus dem Binärsignal ein taktsynchroner Ein-Bit-Datenstrom mit einer gegenüber dem Binärsignal um den Faktor $N$ oder $N + 1$ niedrigeren Abtastrate gewonnen. Hieraus resultiert eine relativ geringe Frequenzauflösung dieses Verfahrens.

Durch die Literaturstelle Ian Galton: Analog-Input Digital Phase-Locked Loops for Precise Frequency and Phase Demodulation, IEEE Trans. Circuits Syst. II, 42:621-630, October 1995, ist ein PLL-Verfahren bekannt geworden, bei dem die Phasendifferenz zwischen dem ankommenden Binärsignal und dem Signal eines digital gesteuerten Oszillators (DCO, digitally controlled oscillator) in einem Integrator in eine analoge Spannung umgesetzt, abgetastet und einem $N$-Bit ADU (in der Literaturstelle ADC genannt) zugeführt wird. Das Ausgangssignal des ADU wird dann nach digitaler Filterung zur Ansteuerung des DCO benutzt. Das quantisierte Binärsignal steht als numerische Folge ($\upsilon(n)$ in der Literaturstelle) zur Verfügung. Die Nachteile dieses PLL-Verfahrens liegen darin, daß ein $N$-Bit ADU benötigt wird, der mit der Frequenz des NCO-Ausgangssignals arbeiten muß. Dabei ist der erforderliche Wert $N$ vom Rauschen abhängig, das dem Binärsignal überlagert sein kann; $N$ ist bei rauschbehafteten Signalen zu erhöhen (siehe S. 626 links in der Literaturstelle). Weiterhin wird auch bei diesem PLL-Verfahren das Regelverhalten über das Schleifenfilter bestimmt, welches im Rückkopplungszweig liegt. Das Regel- und Einschwingverhalten dieses PLL-Verfahrens ist damit vergleichbar mit dem anderer bekannter PLL-Verfahren.

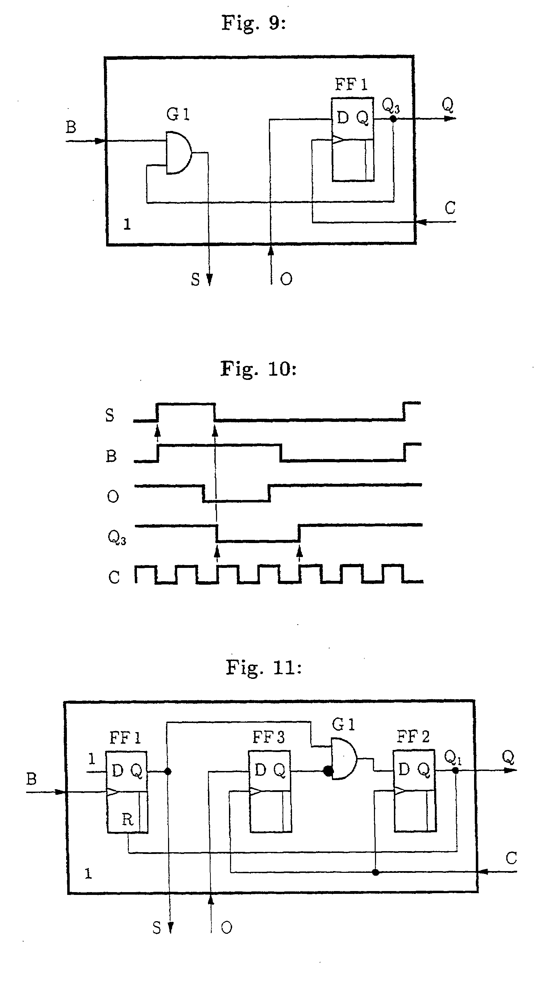

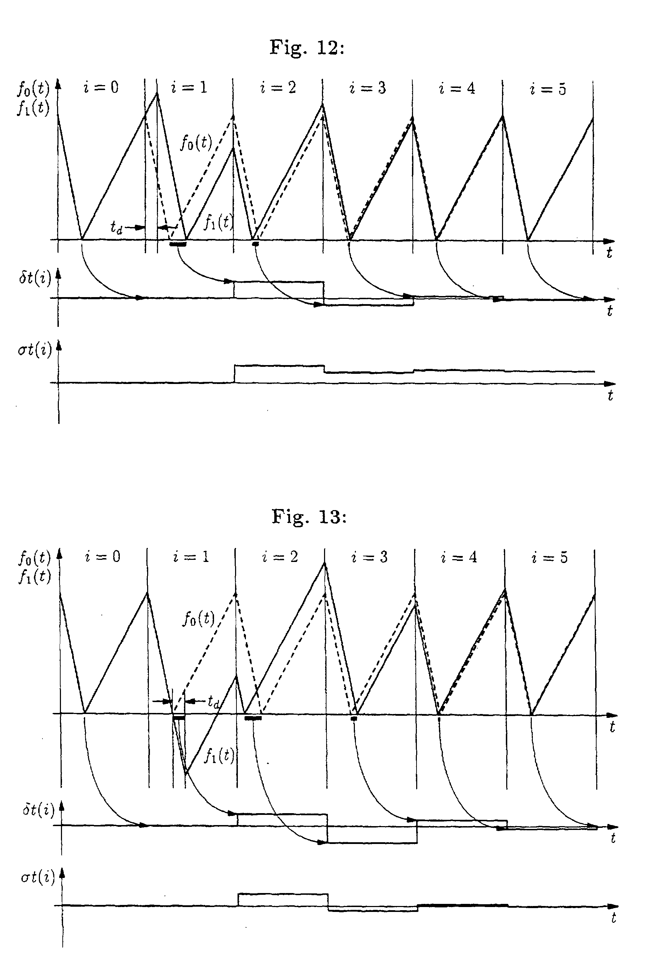

Durch die Literaturstelle Mats Hovin, Alf Olsen, Tor Sverre Lande, Chris Toumazou: Delta-Sigma Modulators Using Frequency-Modulated Intermediate Values, IEEE Journal of Solid-State Circuits, 32(1):13-22, January 1997, ist ein Verfahren bekannt geworden, das nicht auf PLL-Prinzipien basiert, da es keinen steuerbaren Oszillator (VCO oder NCO) aufweist. Es wird als Frequenz-Digital-Umsetzer bezeichnet ($_1$F/D-converter in der Literaturstelle) und zur Quantisierung von Binärsignalen vorgeschlagen. Dieses Verfahren vermeidet den beim Verfahren nach Galton erforderlichen $N$-Bit ADU zur Digitalisierung der Phasendifferenz, und benutzt stattdessen einen 1-Bit-Entscheid mit Hilfe eines Komparators (siehe Fig. 12 in der Literaturstelle). Ein Nachteil dieses Verfahrens besteht in der Erfordernis, zwei zum Oszillatortakt ($f_s$ in Fig. 11 und Fig. 12 in der Literaturstelle) asynchrone Ereignisse abzutasten: Einen $n$-Bit Wert (Ausgang des Blocks ‚mod-$2\pi$+flank counter in Fig. 12 der Literaturstelle), und gleichzeitig die Entscheidung eines Komparators (Steuerleitung ‚*evaluate* in Fig. 12 in der Literaturstelle), wobei sich metastabile Ereignisse und damit einhergehende Quantisierungsfehler nicht sicher vermeiden lassen. Ein zweiter Nachteil dieses Verfahrens liegt darin, daß der Schalter zur Steuerung der Auf- und Entladung des Kondensators über mehrere Takte des Binärsignals ($fm(t)$ in Fig. 11 und Fig. 12 in der Literaturstelle) hinweg nur von diesem selöst gesteuert wird, bis die nächste Flanke des Oszillatortakts ($f_s$ in Fig. 11 und Fig. 12 in der Literaturstelle) eintritt (siehe z. B. Fig. 11 (b) in der Literaturstelle), wodurch sich Ladungsfehler z. B. aufgrund nichtidealer Schalter auf dem Speicherkondensator akkumulieren können. Ein dritter Nachteil des Verfahrens liegt darin, daß aufgrund der Asynchronität des Binärsignals und des Oszillatortakts die Pulsbreite des Ladestroms ($I_c$ in Fig. 11 in der Literaturstelle) beliebig schmal werden kann, was zu Nichtlinearitäten und zusätzlichem Rauschen führen kann, da die Ladung solch schmaler Impulse nur schwer beharrschbar ist.

Technische Aufgabe:

Aufgabe der Erfindung ist es, ein Verfahren zur Quantisierung eines Binärsignals anzugeben, das die Nachteile aller vorgenannten Verfahren vermeidet.

Offenbarung der Erfindung und deren Vorteile:

Die Lösung der Aufgabe besteht in einem Verfahren zur Quantisierung von Binärsignalen, bestehend aus einer digitalen Speicher- und Logikschaltung, einer analogen Filter- und Summierschaltung erster oder höherer Ordnung mit einem oder mehreren Eingängen, einer oder mehreren gesteuerten Quellen für je eine elektrische Größe mit zwei möglichen Werten, die von Quelle zu Quelle verschieden sein können, einem Komparator mit gegebener Schaltschwelle, mit analogem Eingang und Logikausgang, sowie einem Taktgenerator mit gegebener Frequenz, wobei bei jeder Flanke einer gegebener Richtung des Binärsignals die Speicher- und Logikschaltung in einen ersten Ausgangzustand gesetzt wird, hierdurch angesteuert die Quelle(n) je eine elektrische Größe mit einem ersten konstanten Wert liefert/liefern, die Filter- und Summierschaltung diese elektrischen Größe(n) verarbeitet, das Ausgangssignal der Filter- und Summierschaltung während des ersten Ausgangszustandes der Speicher- und Logikschaltung die Schaltschwelle des Komparators durchläuft, worauf dessen Ausgang umschaltet, jeweils beim ersten hierauf folgenden Takt des Taktgenerators oder eine bestimmte Anzahl seiner Takte später die Speicher- und Logikschaltung in einen zweiten Ausgangszustand gesetzt wird, hierdurch angesteuert die Quelle(n) die Filter- und Summierschaltung diese elektrischen Größe(n) solange verarbeitet, bis die nächste Flanke gegebener Richtung des Binärsignals eintritt, so daß die Folge der Zeitpunkte, zu denen die Speicher- und Logikschaltung in den zweiten Ausgangszustand gesetzt wird, als digitales Abbild des Binärsignals genutzt wird.

Vorteilhafte Ausführungsformen der Erfindung sind in den Ansprüchen 2-11 angegeben.

Die Erfindung wird im folgenden anhand von Figuren beschrieben:

**Fig. 1**   zeigt ein Blockschaltbild zur Erläuterung des Hauptanspruchs, Anspruch 1.

**Fig. 2**   zeigt ein weiteres Blockschaltbild zur Erläuterung des Hauptanspruchs, Anspruch 1, mit besonders einfacher Filter- und Summierschaltung.

**Fig. 3**   zeigt ein den Hauptanspruch, Anspruch 1 erläuterndes Zeitdiagramm, für den Sonderfall, daß die analoge Filter- und Summierschaltung nur aus einem Integrator erster Ordnung besteht.

**Fig. 4**   zeigt ein Beispiel einer Speicher- und Logikschaltung.

**Fig. 5**   zeigt ein Zeitdiagramm zur Fig. 4.

**Fig. 6**   zeigt ein Zeitdiagramm mit einem typischen Ausgangssignal einer Filter- und Summierschaltung, die aus einem Integrator erster Ordnung besteht, zusammen mit verschiedenen Logiksignalen.

**Fig. 7**   zeigt ein weiteres Beispiel einer Speicher- und Logikschaltung.

**Fig. 8**   zeigt ein Zeitdiagramm zur Fig. 7.

**Fig. 9**   zeigt ein Beispiel einer stark vereinfachten Speicher- und Logikschaltung, die die Signalwerte des Binärsignals anstelle seiner Flanken auswertet.

**Fig. 10**   zeigt ein Zeitdiagramm zur Fig. 9.

**Fig. 11**   zeigt ein Beispiel einer Speicher- und Logikschaltung, bei der das Ausgangssignal des Komparators vor der Auswertung um einen Takt verzögert wird.

**Fig. 12**   zeigt ein Zeitdiagramm zur Erläuterung des Quantisierungsverhaltens des Verfahrens nach Anspruch 1.

**Fig. 13**   zeigt ein weiteres Zeitdiagramm zur Erläuterung des Quantisierungsverhaltens des Verfahrens nach Anspruch 1.

**Fig. 14**   zeigt ein Beispiel einer Filter- und Summierschaltung zweiter Ordnung.

**Fig. 15**   zeigt typische Signalverläufe einer Filter- und Summierschaltung zweiter Ordnung.

**Fig. 16**   zeigt ein Beispiel einer Filter- und Summierschaltung zweiter Ordnung mit gewichteter Rückführung von Signalanteilen, und mit zwei gesteuerten Quellen.

**Fig. 17**   zeigt ein Beispiel einer Filter- und Summierschaltung $n$-ter Ordnung und mit bis zu $n$ gesteuerten Quellen.

**Fig. 18**   zeigt ein Beispiel einer Filter- und Summierschaltung $n$-ter Ordnung, mit einer gesteuerten Quelle.

**Fig. 19**   zeigt ein Beispiel einer Filter- und Summierschaltung fünfter Ordnung, mit zwei Resonanzstellen, und mit fünf gesteuerten Quellen.

**Fig. 20**   erläutert die Äquivalenz von Um-, Ein-, und Auschaltern bei den gesteuerten Quellen.

**Fig. 21**   zum Anspruch 4 zeigt ein Beispiel, wie die Umschaltmomente der Speicher- und Logikschaltung in eine Digitalimpulsfolge umgesetzt werden können.

**Fig. 22**   zum Anspruch 4 zeigt ein Beispiel, wie die Umschaltmomente der Speicher- und Logikschaltung in eine numerische Folge umgesetzt werden können.

**Fig. 23**   zeigt ein Beispiel eines Dezimationsfilters $n$-ter Ordnung.

**Fig. 24**   zeigt den simulierten Zeitverlauf einer numerischen Ergebnisfolge am Ausgang eines Dezimationsfilters dritter Ordnung.

**Fig. 25**   zeigt ein Addierwerk zur gliedweisen Addition numerischer Folgen, zur Erläuterung der Ansprüche 7 und 8.

**Fig. 26**   zeigt ein Blockschaltbild zur Erläuterung des Anspruchs 10.

**Fig. 27**   zeigt ein Beispiel eines einfachen digitalen Phasenvergleichers.

Das in dieser Erfindung beschriebene Verfahren löst die Aufgabe, ein Binärsignal zu quantisieren.

Bevorzugte Ausführungen der Erfindung:

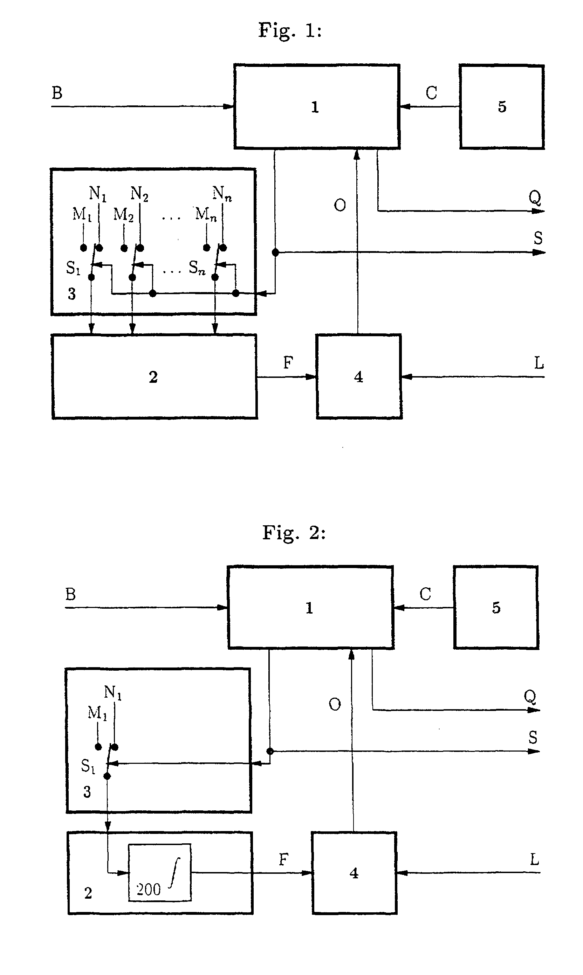

Zur Erläuterung des Hauptanspruchs, Anspruch 1 dient die Fig. 1. In dieser und in den folgenden Figuren sind alle gesteuerten Quellen $S_1 \ldots S_n$, welche im immer im Block 3 zusammengefaßt sind, durch Symbole gesteuerter Umschalter dargestellt, die abhängig vom Ausgangszustand der Speicher- und Logikschaltung 1, dargestellt durch deren Ausgangssignal S, zwischen den Größen $M_1 \ldots M_n$ und $N_1 \ldots N_n$ hin- und herschalten. Diese abstrakte Darstellungsweise der gesteuerten Quellen soll jedoch keinerlei Einschränkung bei deren Ausführung bzw. Realisierung darstellen (z. B. können gesteuerte Quellen auch anders als mit Umschaltern realisiert werden), sondern sie soll ausschließlich der Veranschaulichung dienen, daß der Filter- und Summierschaltung 2 durch die gesteuerten Quellen $S_1 \dots S_n$ bedingt im einen Fall die Größen $M_1 \dots M_n$ mit jeweils einem ersten konstanten Wert, und im anderen Fall die Größen $N_1 \dots N_n$ mit jeweils einem zweiten konstanten Wert zugeführt werden. Weitere Erläuterungen hierzu erfolgen weiter unten. Die in der Fig. 1 und in den folgenden Figuren dargestellte Stellung der Umschalter entspreche dem zweiten Ausgangszustand der Speicher- und Logikschaltung 1.

Gemäß dem Hauptanspruch, Anspruch 1, wird das zu quantisierende Binärsignal B der digitalen Speicher- und Logikschaltung 1 zugeführt.

Bei jeder Flanke des Binärsignals B einer gegebenen Richtung wird die Speicher- und Logikschaltung 1 in einen ersten Ausgangszustand gesetzt, und liefert ein diesem Zustand entsprechendes logisches Ausgangsignal S. Hierdurch angesteuert liefern die Quellen $S_1 \dots S_n$ je eine elektrische Größe mit einem ersten konstanten Wert $M_1 \dots M_n$. Wird insgesamt nur eine gesteuerte Quelle (z.B. $S_1$) verwendet, so wird entsprechend auch nur eine elektrische Größe mit einem ersten konstanten Wert (z. B. $M_1$) geliefert. Für den ersten Ausgangszustand der Speicher- und Logikschaltung 1 verarbeitet die Filter- und Summierschaltung 2 die von der/den gesteuerten Quelle(n) gelieferte(n) elektrischen Größe(n) $M_1 \dots M_n$. Das Ausgangssignal F der Filter- und Summierschaltung 2 durchläuft während des ersten Ausgangszustandes der Speicher- und Logikschaltung 1 die Schaltschwelle L des Komparators 4, worauf dessen Ausgang, Signal 0, umschaltet. Jeweils beim ersten hierauf folgenden Takt (Signal C) des Taktgenerators 5 oder eine bestimmte Anzahl seiner Takte später wird die Speicher- und Logikschaltung 1 in einen zweiten Ausgangszustand gesetzt.

Hierdurch (bzw. durch das entsprechende Signal S) angesteuert liefern die Quellen $S_1 \dots S_n$ je eine elektrische Größe mit einem zweiten konstanten Wert $N_1 \dots N_n$. Entsprechend liefert eine einzelne Quelle (z. B. $S_1$) eine elektrische Größe mit einem zweiten konstanten Wert (z. B. $N_1$). Die Filter- und Summierschaltung 2 verarbeitet diese elektrischen Größe(n) solange, bis die nächste Flanke gegebener Richtung des Binärsignals B eintritt. Die Folge der Zeitpunkte, zu denen die Speicher- und Logikschaltung 1 in den zweiten Ausgangszustand gesetzt wird, wird als digitales Abbild des Binärsignals B genutzt. Diese Folge weist die Frequenz- bzw. Phasenmodulation des Binärsignals auf, zuzüglich einer Phasenmodulation durch ein quantisierungsbedingtes Rauschsignal, dessen Leistungsdichtespektrum mit fallender Frequenz abnimmt.

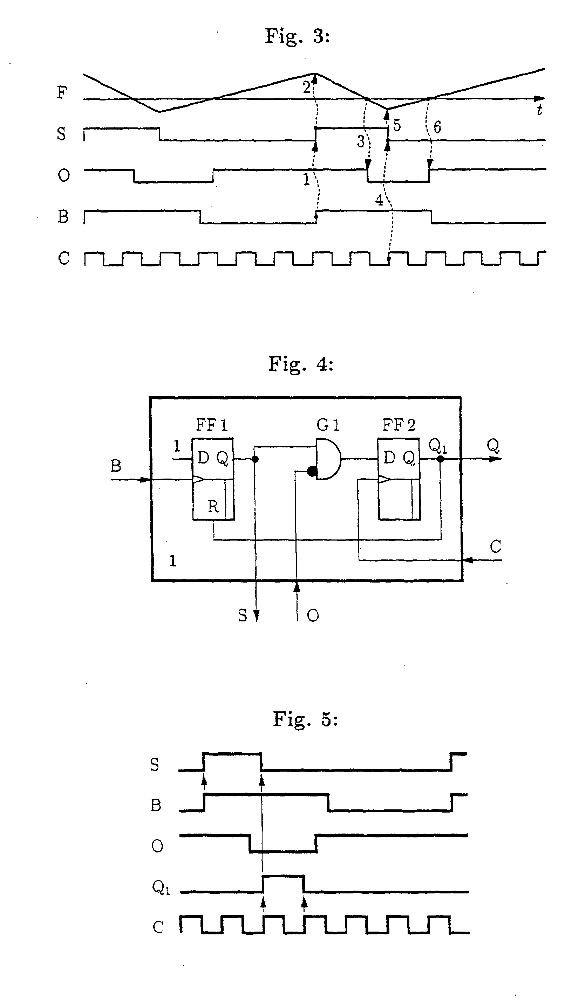

Zur besseren Erläuterung der Erfindung wird ohne Beschränkung der Allgemeinheit zunächst der besonders einfache Fall gewählt, bei dem die analoge Filter- und Summierschaltung 2 nur einen Eingang aufweise, und nur aus einem analogen Integrator 200 bestehe. Das entsprechend vereinfachte Blockschaltbild ist in Fig. 2 gezeigt. Für diesen Fall zeigt Fig. 3 von oben nach unten die Zeitverläufe des analogen Signals F am Ausgang der Filter- und Summierschaltung 2, des Ausgangszustands S der Speicher- und Logikschaltung 1, des Logikausgangs O des Komparators 4, des Binärsignals B, sowie des Taktes C des Taktgenerators 5. Es gelte positive Logik.

Die zeitlichen Abhängigkeiten der Signale sind in der Fig. 3 durch numerierte Schlangenlinien gekennzeichnet. Der Signalwert S='logisch 1' entspreche dem ersten Ausgangszustand der Speicher- und Logikschaltung 1; der Signalwert S='logisch 0' entspreche ihrem zweiten Ausgangszustand.

Weiterhin sei die Richtung der ausgewerteten Flanken des Binärsignals B gegeben: Es werden in diesem Fall die steigenden Flanken ausgewertet (das Verfahren läßt sich ebensogut auch zur Auswertung fallender Flanken eines Binärsignals einsetzen). Ferner sei die Basislinie des analogen Signals F in der Fig. 3 gleichzeitig die Schaltschwelle L des Komparators 5.

Die Fig. 3 zeigt, daß bei jeder steigenden Flanke des Binärsignals B die Speicher- und Logikschaltung 1 in den ersten Ausgangszustand, S = 'logisch 1', gesetzt wird. Dies ist die zeitliche Abhängigkeit Nr. 1.

Der Ausgangszustand S = 'logisch 1' steuert die Quelle $S_1$ an, welche eine elektrische Größe mit einem ersten konstanten Wert $M_1$ liefert. Die Filter- und Summierschaltung 2 verarbeitet (d. h. hier: integriert) die elektrische Größe $M_1$. Dies ist die zeitliche Abhängigkeit Nr. 2.

Da im Block 2 ein Integrator erster Ordnung verwendet wird, ändert sich dessen Ausgangssignal F linear mit der Zeit. Die Polarität der elektrischen Größe $M_1$ sei so gewählt, daß wie dargestellt das Ausgangssignal F der Filter- und Summierschaltung 2 abnimmt, und es die Schaltschwelle L des Komparators 4 während des ersten Ausgangszustandes der Speicher- und Logikschaltung 1 durchläuft. Wird die Schaltschwelle L des Komparators 4 nach unten durchlaufen, schaltet dessen Ausgang O auf 'logisch 0' um. Dies ist die zeitliche Abhängigkeit Nr. 3.

Jeweils beim ersten hierauf folgenden Takt des Taktgenerators 5 oder eine bestimmte Anzahl seiner Takte später wird die Speicher- und Logikschaltung 1 in den zweiten Ausgangszustand, S = 'logisch 0', gesetzt. In diesem Beispiel wird der erste folgende Takt des Taktgenerators 5 benutzt. Dies ist die zeitliche Abhängigkeit Nr. 4.

Der Ausgangszustand S = 'logisch 1' steuert die Quelle $S_1$ an, welche eine elektrische Größe mit einem zweiten konstanten Wert $N_1$ liefert. Die Filter- und Summierschaltung 2 integriert die elektrische Größe $N_1$. Dies ist die zeitliche Abhängigkeit Nr. 5.

Die Polarität der elektrischen Größe $N_1$ sei so gewählt, daß wie dargestellt das Ausgangssignal F der Filter- und Summierschaltung 2 zunimmt. (Wird die Schaltschwelle L des Komparators 4 anschließend nach oben durchlaufen, schaltet dessen Ausgang O wieder auf 'logisch 1' um. Dies ist die zeitliche Abhängigkeit Nr. 6, welche jedoch keinen unmittelbaren Einfluß hat.)

Die Integration mit zunehmendem Signal F erfolgt jeweils solange, bis die nächste steigende Flanke des Binärsignals B eintritt. (Dies wäre die nächste Abhängigkeit Nr. 1, die jedoch in der Fig. 3 nicht mehr dargestellt ist.)

Durch das in der Erfindung beschriebene Verfahren wird erreicht, daß die Flanken am Ausgang S der digitalen Speicher- und Logikschaltung 1 in der einen Richtung von den Flanken einer gegebenen Richtung des Binärsignals B, und in der anderen Richtung von den auf den Takt C synchronisierten Flanken einer Richtung des Signals O vom Ausgang des Komparators 4 bestimmt werden.

Eine sich aus dem beschriebenen Ablauf ergebende Eigenschaft des Verfahrens nach Anspruch 1 ist somit, daß es nach jeder ankommenden Flanke gegebener Richtung des Binärsignals B jeweils eine Flanke des Ausgangszustands S im Taktraster C liefert.

Das Beispiel einer bevorzugten Speicher- und Logikschaltung 1, welche gemäß dem Anspruch 1 arbeitet, ist in Fig. 4 gezeigt, das zugehörige Zeitdiagramm in Fig. 5. Die Speicher- und Logikschaltung 1 besteht hierbei aus zwei D-Flipflops, FF1 und FF2, von denen FF1 asynchron rücksetzbar ist (Eingang R von FF1), sowie einem UND-Gatter G1 mit einem nichtinvertierendem und einem invertierendem Eingang. Das Binärsignal B taktet bei jeder seiner steigenden Flanken das D-Flipflop FF1, welches jeweils das statische Logiksignal 'logisch 1' an seinem D-Eingang übernimmt. Damit wird die Speicher- und Logikschaltung 1 in den Ausgangszustand S = 'logisch 1' gesetzt, und der obere Eingang des Gatters G1 wird logisch 1'.

Wenn der Ausgang O des Komparators 4 auf 'logisch 0' umschaltet, wird der Ausgang des UND-Gatters G1 'logisch 1', und damit auch der D-Eingang des D-Flipflops FF2. Jeweils beim ersten hierauf folgenden Takt (Signal C) des Taktgenerators 5 wird das D-Flipflop FF2 gesetzt, d. h. sein Q-Ausgang $Q_1$ geht auf 'logisch 1'. Dies bewirkt sofort ein Rücksetzen des D-Flipflops FF1 über dessen Rücksetz-Eingang R. Damit befindet sich die Speicher- und Logikschaltung 1 in ihrem zweiten Ausgangszustand, S = 'logisch 0'.

Da nun der Ausgang des UND-Gatters wieder 'logisch 0' ist, wird das D-Flipflop FF2 mit dem folgenden Takt (Signal C) wieder rückgesetzt, so daß es sich für die Dauer eines Taktes des Taktgenerators 5 im Zustand Q = 'logisch 1' befand.

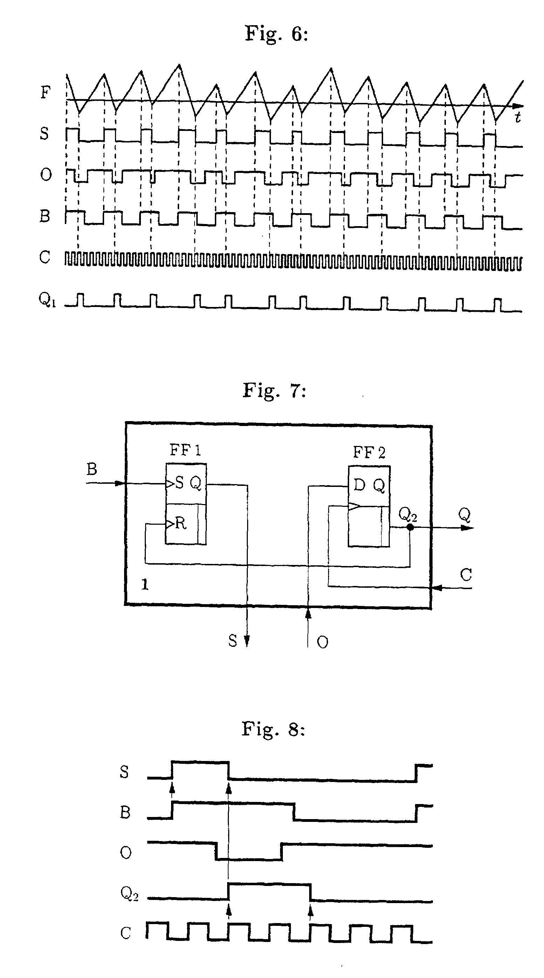

Für den Fall eines Integrators erster Ordnung entsteht am Integratorausgang F ein Signal mit dreieckförmigem Verlauf, für den die Fig. 6 ein typisches Beispiel (über ca. 12 Takte des Binärsignals B aufgenommen) zeigt. Die Fig. 6 zeigt auch unten den Signalverlauf am Q-Ausgang $Q_1$ des Flipflops FF2 der Speicher- und Logikschaltung 1 aus der Fig. 4.

Außer der beschriebenen Speicher- und Logikschaltung 1 nach Fig. 4 gibt es weitere Beispiele solcher Schaltungen, die gemäß dem Anspruch 1 arbeiten. Die Fig. 7 zeigt ein Beispiel, das mit einem flankengesteuerten RS-Flipflop FF1 und einem D-Flipflop FF2 arbeitet; das zugehörige Zeitdiagramm zeigt die Fig. 8: Das Binärsignal B taktet bei jeder seiner steigenden Flanken den S-Eingang des RS-Flipflops FF1, wodurch dessen Q-Ausgang, und damit der Ausgang S der Speicher- und Logikschaltung 1 in den ersten Ausgangszustand, S = 'logisch 1', gesetzt wird. Wenn der Ausgang des Komparators 4 nach 'logisch 0' umschaltet, wird beim ersten hierauf folgenden Takt (Signal C) des Taktgenerators 5 das D-Flipflop FF2 rückgesetzt, und dieses taktet sofort über seinen $\overline{Q}$-Ausgang $Q_2$ den R-Eingang des RS-Flipflops FF1, wodurch dessen Q-Ausgang, und damit der Ausgang S der Speicher- und Logikschaltung 1 in den zweiten Ausgangszustand, S = 'logisch 0', gesetzt wird.

Es ist z. B. auch möglich, eine solche Schaltung nur unter Verwendung eines einzelnen D-Flipflops aufzubauen, und, anstatt die Flanken des Binärsignals B einer gegebenen Richtung auszuwerten, seine Signalwerte zu nutzen. Ein Beispiel hierzu zeigt die Fig. 9, das zugehörige Zeitdiagramm zeigt die Fig. 10: Die Speicher- und Logikschaltung 1 wird bei jeder steigenden Flanke des Binärsignals B in ihren ersten Ausgangszustand gesetzt, S = 'logisch 1', indem die UND-Bedingung an den Eingängen des Gatters G1 erfüllt ist. Wenn der Ausgang O des Komparators 4 nach 'logisch 0' umschaltet, wird beim ersten hierauf folgenden Takt (Signal C) des Taktgenerators 5 das D-Flipflop FF1 rückgesetzt, womit sofort auch die UND-Bedingung am Gatter G1 nicht mehr erfüllt ist. Damit wird die Speicher- und Logikschaltung 1 in den zweiten Ausgangszustand gesetzt, S = 'logisch 0'. Der Nachteil einer solchen Speicher- und Logikschaltung 1 gemäß Fig. 9 ist, daß ihre zwei Ausgangszustände nicht nur von den Signalflanken des Binärsignals B, sondern auch von seinen Signalwerten und deren Puls/Pausen-Verhältnis abhängen. Eine solche Abhängigkeit gilt hierbei auch bezüglich des Signals O vom Ausgang des Komparators 4. Besonders wenn die Frequenz des Taktgenerators nur ein mehrfaches der Frequenz des Binärsignals B ist, kann die Speicher- und Logikschaltung 1 Fig. 9 zu Instabilitäten bei der Quantisierung führen. So ergibt sich z. B. eine fehlerhafte Quantisierung des Binärsignals B, wenn der Q-Ausgang des D-Flipflops FF1 in Fig. 9 bereits wieder nach nach 'logisch 1' geht (weil im Takt zuvor der Ausgang O des Komparators 4 nach 'logisch 1' geschaltet hatte), während das Binärsignal B noch 'logisch 1' ist.

Daher sind im allg. Speicher- und Logikschaltungen 1 zu bevorzugen, bei denen nur die Flanken des Binärsignals B ausgewertet werden, wie z. B. in den Fig. 4 und 7 gezeigt.

Gemäß dem Anspruch 1 wird die Folge der Zeitpunkte, zu denen die Speicher- und Logikschaltung 1 in den zweiten Ausgangszustand gesetzt wird, als digitales Abbild des Binärsignals B genutzt. Dies setzt voraus, daß die genannte Folge der Zeitpunkte von der Speicher- und Logikschaltung 1 nach außen zur Verfügung gestellt wird. Hierzu werden in den Fig. 1 und 2 zwei Ausgangssignale der Speicher- und Logikschaltung 1 gezeigt, das Signal S und das Signal Q, welche alternativ verwendet werden können:

Zum einen ist die Folge der Zeitpunkte, zu denen die Speicher- und Logikschaltung 1 in den zweiten Ausgangszustand gesetzt wird, im Signal S enthalten; in der Fig. 3 beispielsweise sind diese Zeitpunkte jeweils durch die fallenden Flanken des Signals S markiert. Hierbei ist zu beachten, daß jede zweite Flanke des Signals S von einer Flanke des Binärsignals B bestimmt wird, und meist nicht im Taktraster des Taktgenerators 5 liegt; in der Fig. 3 sind dies jeweils die steigenden Flanken des Signals S. Daher ist das Signal S entsprechend so weiterzuverarbeiten, daß nur die Flanken des Signals S berücksichtigt werden, bei denen die Speicher- und Logikschaltung 1 jeweils in den zweiten Ausgangszustand gesetzt wird.

Zum zweiten kann man die Folge der Zeitpunkte, zu denen die Speicher- und Logikschaltung 1 in den zweiten Ausgangszustand gesetzt wird, häufig auch aus einem internen Logiksignal der Speicher- und Logikschaltung 1 ableiten, wie die folgenden Beispiele erläutern: Bei der Speicher- und Logikschaltung 1 nach Fig. 4 kann das Signal $Q_1$ als Ausgangssignal Q der Speicher- und Logikschaltung 1 verwendet werden, denn es ist bei jeden Takt des Binärsignals B für genau einen Takt des Taktgenerators 5 im Zustand $Q_1$ = 'logisch 1' (siehe hierzu Fig. 5 und Fig. 6), und markiert hierdurch die gesuchte Folge von Zeitpunkten. Bei der Speicher- und Logikschaltung 1 nach Fig. 7 ist die Folge der Zeitpunkte, zu denen die Speicher- und Logikschaltung 1 in den zweiten Ausgangszustand gesetzt wird, im Signal $Q_2$ am $\overline{Q}$-Ausgang des D-Flipflops FF2 enthalten, welches jedem Zustandswechsel am Ausgang O des Komparators 4 beim nächsten Takt des Taktgenerators 5 invertierend folgt (siehe hierzu Fig. 8). Daher kann hier das Signal $Q_2$ als Ausgangssignal Q der Speicher- und Logikschaltung 1 verwendet werden; jedoch ist für die weitere Verarbeitung des Signals $Q_2$ zu beachten, daß dessen Pulsbreite nicht konstant ist, und bei den gegebenen Signalpolaritäten nur die steigenden Flanken des Signals $Q_2$ die gesuchten zeitlichen Positionen markieren.

Bei anderen Speicher- und Logikschaltungen 1 können im allg. ebenfalls interne Logiksignale gefunden werden, welche sich als Ausgangssignal Q eignen.

Gemäß dem Anspruch 1 wird jeweils beim ersten auf das Umschalten des Komparators 4 folgenden Takt des Taktgenerators 5 oder eine bestimmte Anzahl seiner Takte später die Speicher- und Logikschaltung 1 in einen zweiten Ausgangszustand gesetzt. Mit dieser Wahlmöglichkeit ist gemeint, daß das Ausgangssignal O des Komparators 4 vor seiner Auswertung auch verzögert werden kann. Die Verzögerung kann z. B. digital um einen oder mehrere Takte des Taktgenerators 5 erfolgen, z. B. in einem weiteren D-Flipflop oder einer Kette aus mehreren D-Flipflops, oder in einer Logikschaltung, welche kurze Störimpulse unterdrückt. Dies erlaubt es, bei der Abtastung des Signals O, dessen Flanken im allg. nicht synchron zum Takt des Taktgenerators sind, Vorkehrungen zur Unterdrückung kurzer Störimpulse, oder zur Verringerung der Wahrscheinlichkeit sogenannter metastabiler Zustände zu treffen.

Die Fig. 11 zeigt ein Beispiel einer Speicher- und Logikschaltung 1, die nach dem Umschalten des Komparators 4 nicht im folgenden Takt, sondern erst einen Takt später in einen zweiten Ausgangszustand gesetzt wird. Die Synchronisierung des Ausgangssignal O des Komparators 4 auf das Taktraster (Signal C) erfolgt hier zunächst in dem D-Flipflop FF 3, die weitere Verarbeitung des Signals O ist wie in der Fig. 4.

Ein Vergleich der fallenden Flanken des Signals S mit den Flanken des Binärsignals B in der Fig. 6 zeigt, daß mit Hilfe des Verfahrens nach Anspruch 1 das Binärsignal B in ein digital pulspositionsmoduliertes Signal (sogenanntes digitales PPM-Signal) umgesetzt wird. Letzteres wird durch die (bei der hier gewählten Polarität) fallenden Flanken des Signals S dargestellt, oder auch—abhängig von der Wahl der Speicher- und Logikschaltung 1—durch das Signal Q (z. B. bei der Speicher- und Logikschaltung 1 gemäß Fig. 4 durch die Impulsfolge $Q_1$).

Die fallenden Flanken des Signals S sind gegenüber den Flanken des Binärsignals B quantisierungsbedingt um variable Zeitdifferenzen versetzt, und daher im allg. nicht äquidistant. Der Grund hierfür ist, daß die fallenden Flanken des Signals S im Zeitraster des Taktes C liegen, das Binärsignal B jedoch im allg. nicht. Zweitens sind aufgrund der rückgekoppelten Struktur des Verfahrens nach Anspruch 1 die Positionen der fallenden Flanken des Signals S zeitmoduliert, woraus sich die besonderen Vorteile des Verfahrens bezüglich des Quantisierungsrauschens ergeben, welche im folgenden erläutert werden.

Zunächst wird das Impulsantwortverhalten des Verfahrens nach Anspruch 1 betrachtet. Mit Impulsantwort ist hierbei eine Zeitdifferenz-Impulsantwort gemeint, d.h. die Reaktion des Verfahrens auf einzelne zeitlich verschobene Signalflanken des Binärsignals B. In guter Näherung kann hieraus auf das Quantisierungsverhalten des Verfahrens im Frequenzbereich geschlossen werden. Die Betrachtungen verwenden Simulationen eines linearisierten Modells des Quantisierungsverfahrens; genauere Analysen erfordern aufwendigere Simulationen mit geeigneten Rechnerprogrammen.

Es werden zwei Fälle betrachtet : 1. Die Impulsantwort des Verfahrens bezüglich einzelner zeitverschobener Flanken eines sonst periodischen festfrequenten Binärsignals B; dies läßt Rückschlüsse zu, wie das Verfahren auf frequenz- bzw. phasenvariable Binärsignale reagiert. 2. Die Impulsantwort des Verfahrens auf Verzögerung des Komparatorausgangssignals O; dies läßt Rückschlüsse auf das zugefügte Quantisierungsrauschen (Zeit- oder Phasenrauschen) und dessen Verhalten im Frequenzbereich zu.

Um beide Impulsantworten separieren zu können, wird zunächst das Quantisierungsrauschen vernachlässigt, indem z. B. die Frequenz des Taktes C viel größer als diejenige des Binärsignals B sei. Die Fig. 12 zeigt oben gestrichelt den Zeitverlauf des Signals $f_0(t)$ am Ausgang F einer Filter- und Summierschaltung 2 erster Ordnung für 5 Perioden eines konstantfrequenten Binärsignals B. Man erkennt, daß das Verfahren eingeschwungen ist, da der Signalverlauf $f_0(t)$ mit jedem Takt wiederkehrt. Die Frequenz des Taktes C ist hierbei so groß, daß die Speicher- und Logikschaltung 1 beim Umschalten des Komparators 4 jeweils sofort in ihren zweiten Ausgangszustand gesetzt wird.

Zusätzlich ist gezeigt, wie das Verfahren auf zeitliche Verschiebung einer einzelnen Flanke des Binärsignals reagiert. Hierzu wird nur im Takt mit dem Index $i$ = 1 die Flanke des Binärsignals B um die Zeit $t_d$ verzögert, so daß die Speicher- und Logikschaltung 1 in diesem Takt um $t_d$ verspätet in ihren ersten Ausgangszustand gesetzt wird. Dann entsteht am Ausgang F der Filter- und Summierschaltung 2 der Signalverlauf $f_1(t)$ (im Takt mit $i$ = 0 liegen die Verläufe $f_0(t)$ und $f_1(t)$ übereinander).

Die Fig. 12 zeigt, daß die Zeitpunkte, zu denen das Signal $f_1(t)$ in den folgenden Takten die Schaltschwelle des Komparators 4 (die Grundlinie in der Fig. 12) erreicht, um die Zeitpunkte für den eingeschwungenen Fall schwanken. Die entsprechenden Zeitdifferenzen sind in der Fig. 12 durch dickere horizontale Linien gekennzeichnet. Nach mehreren Takten ist das Verfahren wieder eingeschwungen, die Zeitdifferenzen gehen gegen Null.

Diese Zeitdifferenzen sind als $\delta t(i)$ bezeichnet und im Graph darunter vertikal als Treppenfunktion aufgetragen. Man erkennt, daß der einzelne Zeitdifferenz-Impuls $t_d$ eine Zeitdifferenz-Impulsantwort der Zeitpunkte bewirkt, zu denen die Speicher- und Logikschaltung 1 in ihren zweiten Ausgangszustand gesetzt wird. Diese Zeitdifferenz-Impulsantwort hat einen Gleichanteil, wie man auch dem Graph $\sigma t(i)$ ganz unten entnehmen kann, welcher die Summation der Zeitdifferenzen $\delta t(i)$ zeigt.

Der Gleichanteil in der Zeitdifferenz-Impulsantwort besagt, daß eine (auch beliebig langsame, niederfrequente) zeitliche Modulation der Flanken des Binärsignals B in eine entsprechende zeitliche Modulation der Zeitpunkte, zu denen die Speicher- und Logikschaltung 1 jeweils in den zweiten Ausgangszustand gesetzt wird, umgesetzt wird. D. h., das so simulierte Verfahren folgt mit seinem Ausgangssignal (oben beschriebene Flanken des Signals S bzw. Q) im Mittel frequenz- und phasentreu (mit einem Phasenversatz) dem frequenz- bzw. phasenvariablen Binärsignal B an seinem Eingang.

Ist die Frequenz des Taktgenerators 5 nicht so hoch, daß ihr Einfluß auf die Quantisierung vernachlässigt werden kann, so ist der Quantisierungsvorgang komplexer: Jedesmal nach dem Umschalten des Komparatorausgangs O entsteht ein nicht vernachlässigbarer variabler Zeitverzug, bis die Speicher- und Logikschaltung 1 im folgenden Takt des Taktgenerators 5 oder eine bestimmte Anzahl seiner Takte später in einen zweiten Ausgangszustand gesetzt wird. Hierdurch wird dem Ausgangssignal S bzw. Q des Verfahrens nach Anspruch 1-2 ein Quantisierungsrauschen zugefügt, in Form einer Zeit- oder Phasenmodulation der Signalflanken.

Zur Erläuterung der prinzipiellen Struktur dieser Zeit- oder Phasenmodulation wird die Zeitdifferenz-Impulsantwort des Verfahrens auf die Verzögerung einer einzelnen Signalflanke am Komparatorausgang O betrachtet. Die Fig. 13 zeigt wieder oben gestrichelt den Zeitverlauf des Signals $f_0(t)$ am Ausgang F einer Filter- und Summierschaltung 2 erster Ordnung für 5 Perioden eines konstantfrequenten Binärsignals B für den eingeschwungenen Fall, wobei wieder der Einfluß des Taktgenerators 5 vernachlässigbar sei, d. h. seine Frequenz sei sehr groß.

Im Takt mit dem Index $i$ = 1 wird eine künstliche Zeitverzögerung $t_d$ eingeführt, welche einmalig ein verspätetes Setzen der Speicher- und Logikschaltung 1 in ihren zweiten Ausgangszustand bewirkt. Hierdurch ergibt sich am Ausgang der Filter- und Summierschaltung der Signalverlauf $f_1(t)$. Auch diesmal schwanken die Zeitpunkte, zu denen das Signal $f_1(t)$ in den folgenden Takten die Schaltschwelle des Komparators 4 (die Grundlinie in der Fig. 13) erreicht, um die Zeitpunkte für den eingeschwungenen Fall, was durch die dickeren horizontalen Linien gekennzeichnet ist. Nach mehreren Takten ist das Verfahren wieder eingeschwungen, die Zeitdifferenzen $\delta t(i)$ gehen gegen Null.

Die Folge der Zeitdifferenzen $\delta t(i)$ in der Fig. 13, mit denen das Verfahren auf die Verzögerung einer einzelnen Signalflanke am Komparatorausgang O antwortet, ist eine mit der halben Frequenz des Binärsignals B geträgerte abklingende Stufenfunktion. Diese Zeitdifferenz-Impulsantwort besitzt keinen Gleichanteil, wie der Graph $\sigma t(i)$ in der Fig. 13 zeigt. Die Fourier-Transformierte dieser Zeitdifferenz-Impulsantwort enthält folglich bei niedrigen Frequenzen nur sehr geringe Spektralanteile; diese sind zu höheren Frequenzen hin verschoben (z. B. in die Nähe der halben Frequenz des Binärsignals B).

Von dieser charakteristischen Zeitdifferenz-Impulsantwort kann nun auf das Zeit-bzw. Phasenrauschverhalten des Quantisierungsverfahrens geschlossen werden: Bei regulärem Betrieb des Quantisierungsverfahrens ist die Periodendauer des Taktes C im allg. klein gegenüber derjenigen des zu quantisierenden Binärsignals B (z. B. 1/6). Daher kann angenommen werden, daß bei der Abtastung des Komparatorausgangs O mit jedem Takt des Binärsignals B eine neue Zeitdifferenz $t_d$ entsteht, die in guter Näherung zeitlich gleichverteilt über eine Taktperiode des Taktgenerators 5 auftritt. Die Folge der Zeitdifferenzen $t_d$ kann als weiße Zeit-Rauschfolge angesetzt werden (vergleichbare Betrachtungsweisen sind für das Quantisierungsrauschen von Analog-Digital-Umsetzern bekannt).

Das hierdurch im Signal S bzw. Q enthaltene quantisierungsbedingte Zeit- bzw. Phasenrauschen ergibt sich in guter Näherung durch Faltung einer solchen spektral weißen Zeit-Rauschfolge mit der gleichanteilfreien Zeitdifferenz-Impulsantwort des Verfahrens, wie z. B. der Folge $\delta t(i)$ in der Fig. 13. Daher weist das Signal S bzw. Q zusätzlich zur Frequenz- bzw. Phasenmodulation des Binärsignals B eine weitere Phasenmodulation durch ein quantisierungsbedingtes Rauschsignal mit nur geringen Spektralanteilen bei niedrigen Frequenzen auf. Das Leistungsdichtespektrum dieses Rauschsignals nimmt mit fallender Frequenz ab (was z. B. durch Frequenz- bzw. Phasendemodulation des Signals S bzw. Q nachgewiesen werden kann), und ist am geringsten dicht bei der Frequenz Null.

Hieraus resultiert als wesentliche vorteilhafte Eigenschaft des Quantisierungsverfahrens nach dem Anspruch 1-3, daß das bei einer Frequenz- bzw. Phasendemodulation des Signals S bzw. Q entstehende Nutzsignal im Basisband von einem Quantisierungsrauschen überlagert ist. das in diesem Frequenzbereich nur sehr geringe Leistungsanteile aufweist. Stattdessen liegen die wesentlichen Spektralanteile dieses Quantisierungsrauschens bei geeigneter Dimensionierung des Verfahrens außerhalb des Nutzsignalbandes. Sie können daher leicht durch analoge oder digitale Filterung entfernt werden.

Das in dieser Erfindung beschriebene Verfahren zur Quantisierung von Binärsignalen ist strukturell verwandt mit den bekannten $\Delta\Sigma$-Analog/Digital- (A/D)-Umsetzern, welche zur Quantisierung von Spannungen oder Strömen benutzt werden. Die analog/digitalen Eingangsstufen dieser $\triangle\Sigma$-A/D-Umsetzer weisen wie das Verfahren aus dieser Erfindung rückgekoppelte Strukturen auf, in denen ebenfalls mit Hilfe von integrierenden Filter- und Summierschaltungen das zugefügte Quantisierungsrauschen spektral beeinflußt wird, so daß das Leistungsdichtespektrum des im Quantisierungsergebnis enthaltenen Rauschens im allg. ebenfalls mit fallender Frequenz abnimmt, und seine wesentlichen Leistungsanteile außerhalb des Nutzsignalbandes liegen. Dies wird als Rauschformung (engl. 'noise shaping') bezeichnet.

Die strukturelle Ähnlichkeit des Verfahrens aus dieser Erfindung mit den $\Delta\Sigma$-A/D-Umsetzern gestattet es, die von letzteren bekannten Topologien der Filter- und Summierschaltungen mit geringen Modifikationen auch auf das Verfahren dieser Erfindung anzuwenden. Hierbei ist zu beachten, daß die bei $\Delta\Sigma$-A/D-Umsetzern verwendeten Filter- und Summierschaltungen im allg. abgetastete Systeme sind, welche häufig in Schalter-Kondensator- (S/C)-Technologie aufgebaut sind. Für das Verfahren aus dieser Erfindung hingegen sind die analogen zeitkontinuierlichen Entsprechungen dieser Filter- und Summierschaltungen zu verwenden. Ein weiterer Unterschied zu den $\Delta\Sigma$-A/D-Umsetzern ist, daß deren Filter- und Summierschaltungen Eingänge für die zu messenden Spannungen bzw. Ströme aufweisen. Die Filter- und Summierschaltungen dieser Erfindung kommen ohne solche Eingänge aus, und erhalten ihre Eingangsgröße(n) nur über oder die gesteuerten Quelle(n). Werden Filter- und Summierschaltungen von $\Delta\Sigma$-A/D-Umsetzern für das Quantisierungsverfahren dieser Erfindung adaptiert, so können die entsprechenden unbenutzten Eingänge weggelassen oder auf einen festen Signalwert (z. B. Null) gelegt werden.

Beispiele bevorzugter zeitkontinuierlichen Filter- und Summierschaltungen 2 für das Verfahren aus dieser Erfindung sind im folgenden anhand von mehreren Figuren kurz beschrieben. Eine Filter- und Summierschaltung erster Ordnung, d. h. mit nur einem Integrator 200, wurde bereits in der Fig. 2 gezeigt.

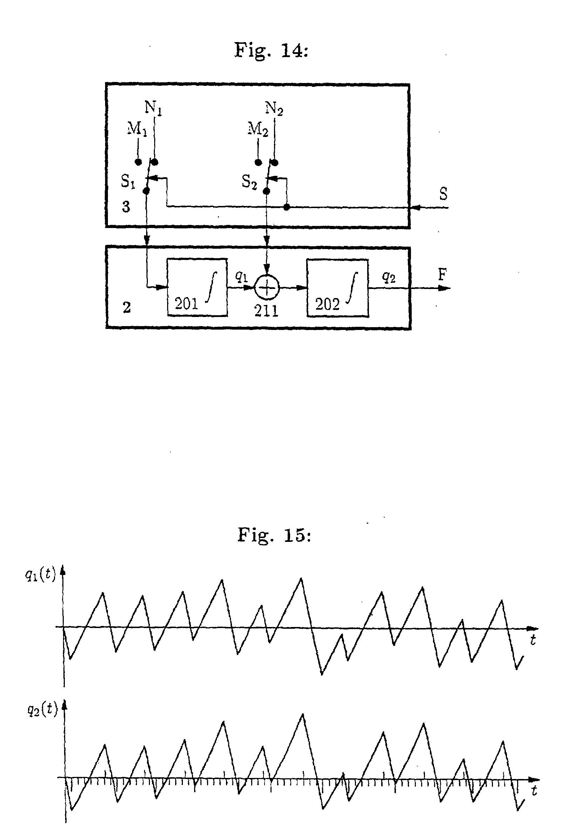

Durch Zufügen eines weiteren Integrators erhält man eine Filter- und Summierschaltung 2 zweiter Ordnung, wie sie in der Fig. 14 gezeigt ist. Zur Ansteuerung werden zwei gesteuerte Quellen $S_1$ und $S_2$ verwendet. Die beiden Integratoren 201 und 202 sind über das analoge Summierglied 211 zusammengeschaltet. Ein Beispiel für typische Signalverläufe an den Ausgängen der beiden Integratoren zeigt die Fig. 15. Der Zeitverlauf des Signals $q_1(t)$ am Aus-gang des Integrators 201 besteht aus Geradenstücken, der Zeitverlauf des Signals $q_2(t)$ am Ausgang des Integrators 202 hingegen aus Parabelstücken. Bei der Grundlinie des Signals $q_2(t)$ sind weiterhin mit kurzen Strichen markiert die relevanten Taktflanken des Taktgenerators 5, die ausgewerteten Flanken des Binärsignals B, sowie die Zeitpunkte, zu denen die Speicher- und Logikschaltung 1 in den zweiten Ausgangszustand gesetzt wird. Gegenüber der Filter- und Summierschaltung erster Ordnung nach Fig. 2 ergibt die Schaltung nach Fig. 14 ein verbessertes Phasen-Rauschformungsverhalten: Das Leistungsdichtespektrum des nach der Frequenz- bzw. Phasendemodulation des Signal S bzw. Q dem Nutzsignal überlagerten Rauschens nimmt zur Frequenz Null hin steiler ab, wobei das Nutzsignal im interessierenden Basisband einen entsprechend geringeren Rauschanteil enthält.

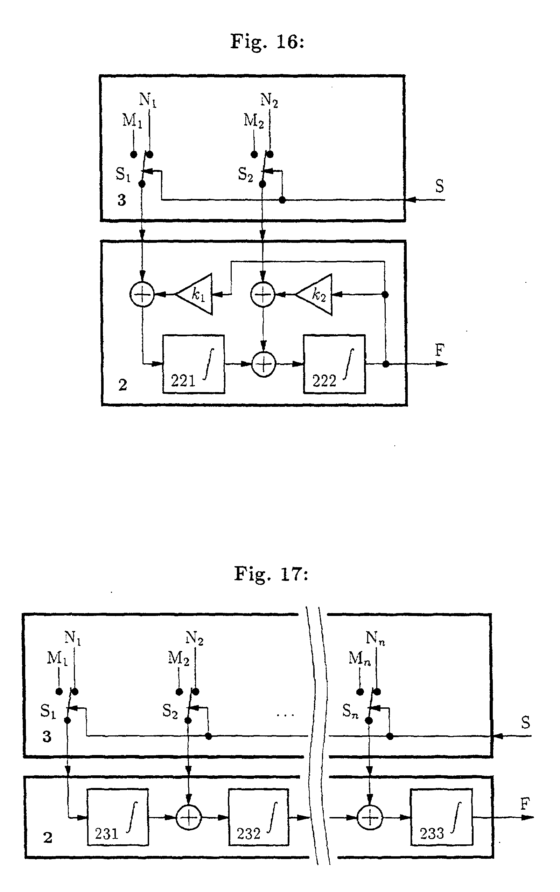

Durch Zufügung weiterer analoger Summierglieder und einer gewichteten Rückführung von Signalanteilen des zweiten Integrators kann das Phasen-Rauschformungsverhalten des Quantisierungsverfahrens modifiziert werden. Das Beispiel einer solchen Filter- und Summierschaltung 2 zweiter Ordnung zeigt die Fig. 16. Durch Einstellung des Verstärkungsfaktors $k_2$ kann das nichtideale Verstärkungsverhalten des Integrators 222 optimiert werden, und durch den Faktor $k_1$ können die Dämpfungspole für das Phasen-Quantisierungsrauschen in der Frequenzebene ver-schoben werden.

Wie von $\Delta\Sigma$-A/D-Umsetzern bekannt, ergeben beim Verfahren aus dieser Erfindung Filter- und Summierschaltungen höherer Ordnung ein weiter verbessertes Rauschformungsverhalten. Man kann z.B. erreichen, daß das nach der Frequenz- bzw. Phasendemodulation des Signals S bzw. Q dem Nutzsignal überlagerte Rauschen in seinem Leistungsdichtespektrum zu niedrigen Frequenzen hin noch steiler abnimmt. Ein Beispiel für eine Filter- und Summierschaltung 2 $n$-ter Ordnung zeigt die Fig. 17. Hierbei sind eine Anzahl von $n$ Integratoren in Serie geschaltet, und durch analoge Summierglieder 231, (**232**)...**(233)** werden die von den gesteuerten Quellen $S_1 ... S_n$ kommenden Größen hinzuaddiert. Es müssen auch nicht alle gesteuerten Quellen $S_1 ... S_n$ vorhanden sein, sondern das Verfahren arbeitet bei geeigneter Wahl der Größen $M_1$; $N_1 ... M_n$; $N_n$ auch mit einer Untermenge aus diesen Größen bzw. gesteuerten Quellen.

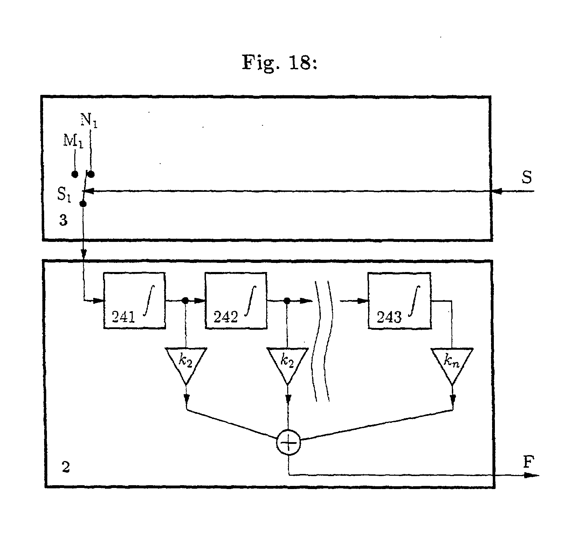

Analog zu den $\triangle\Sigma$-A/D-Umsetzern können auch Filter- und Summierschaltungen verwendet werden, welche sich aus anderen durch Invertierung der Signalfluß-Graphen ergeben. Als Beispiel hierzu zeigt die Fig. 18 eine Filter- und Summierschaltung 2 *n*-ter Ordnung, die ihre Eingangsgröße nur über eine gesteuerte Quelle erhält, und ebenfalls durch den Anspruch 1 abgedeckt ist.

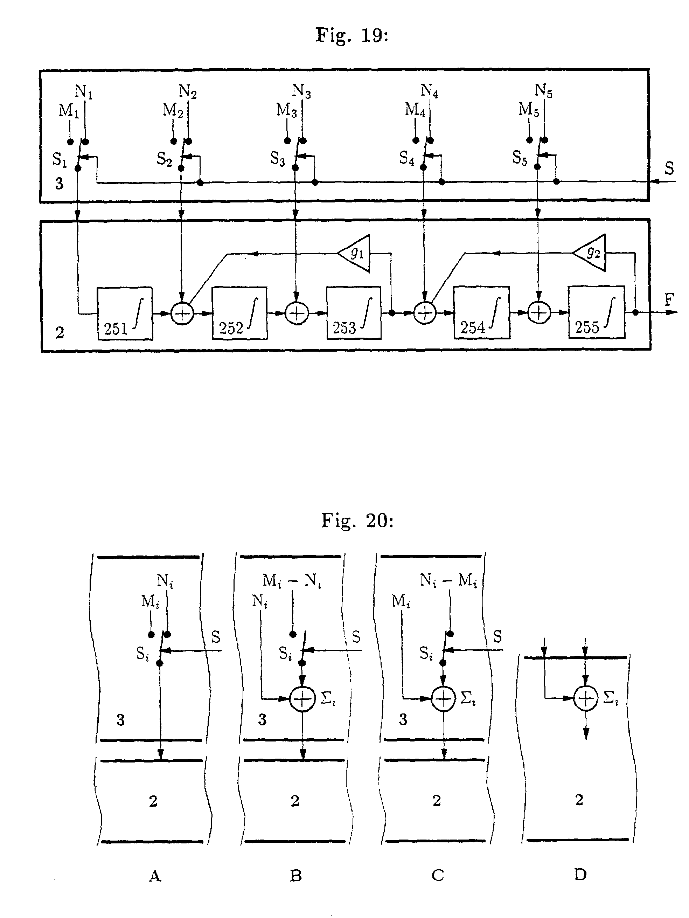

Der Einfluß des Phasen-Quantisierungsrauschens auf das Nutzsignal im Basisband läßt sich mitunter besonders günstig unterdrücken, indem eine Filter- und Summierschaltung mit einer oder mehreren Resonanzstellen eingesetzt wird, was zusätzliche Dämpfungspole für das Phasen-Quantisierungsrauschen in der Frequenzebene ergibt. Das Beispiel einer solchen Filter- und Summierschaltung 2 zeigt die Fig. 19. Diese Filter- und Summierschaltung 2 mit 5. Ordnung weist zwei Resonanzstellen auf, die durch die Konstanten $g_1$ und $g_2$ eingestellt werden.

Außer den gezeigten Beispielen von analogen Filter- und Summierschaltungen lassen sich auch viele von $\Delta\Sigma$-A/D-Umsetzern bekannte Filter- und Summierschaltungen für das Quantisierungsverfahren dieser Erfindung adaptieren. Mit Hilfe von Verfahren der Netzwerk- oder Filtersynthese lassen sich aus den kanonischen Formen der Filter- und Summierschaltungen für die praktische Realisierung viele neue Schaltungen ableiten.

Bei den analogen Filterstrukturen eignen sich sowohl Kapazitäten, als auch Induktivitäten als Energiespeicher. Die parasitären Kapazitäten und Induktivitäten der (aktiven) Schaltungselemente dürfen nicht außer acht gelassen, aber können oft nutzbringend eingesetzt werden. Dies ist vor allem interessant bei hochfrequenten Binärsignalen vom VHF-Bereich bis weit in den Gigahertzbereich hinein.

Quantisierer für hochfrequente Binärsignale lassen sich mitunter besonders gut mit Filtern bzw. Integratoren aufzubauen, bei denen Kondensatoren, die einseitig auf Masse liegen, durch gesteuerten Stromquellen (z. B. durch Operational Transductance Amplifiers, 'OTAs' realisiert) auf- bzw. entladen werden.

Die Erfindung gemäß Anspruch 1 weist unter anderem folgende Vorteile auf: Sie erlaubt die Quantisierung eines Binärsignals, bzw. die Umsetzung des Signals auf ein digitales Taktraster, wobei das zugefügte Phasen-Quantisierungsrauschen durch Rauschformung nur einen minimalen Einfluß auf das modulierende Nutzsignal im Basisband (d. h. auf die im Binärsignal B enthaltene Frequenz bzw. Phaseninformation) hat. Gegenüber PLL-Schaltungen benötigt die Erfindung gemäß Anspruch 1 keinen NCO, und auch keine analogen oder digitalen Schleifenfilter, welche bei PLLs häufig Stabilitätsprobleme ergeben. Es wird kein gesonderter Analog/Digital-Umsetzer zur Quantisierung benötigt. Das Verfahren dieser Erfindung zeigt ein extrem schnelles Einschwingen bei Frequenz- und Phasensprüngen an seinem Eingang innerhalb weniger Takte des Binärsignals B. Entgegen dem Stand der Technik muß nur ein einziges inneres Signal (der Ausgang O des Komparators 4) auf ein gegebenes Taktraster synchronisiert werden. Es treten also keine asynchronen Mehrkomponentenübergänge auf, so daß die Gefahr falscher innerer Zustände oder metastabiler Zustände minimiert ist. Da die gesteuerte(n) Quelle(n) des Verfahrens nach Anspruch 1 jeweils ihre elektrische Größe nur mit zwei möglichen Werte liefern können, ergibt sich eine einfache digitale Ansteuerung und ein sehr geringer analoger Schaltungsaufwand, woraus auch ein günstiges Verhalten bezüglich des Rauschens der Schaltflanken und des thermischen Rauschen der analogen Schaltungskomponenten folgt. Ferner sind die inneren Signalverläufe besonders übersichtlich.

Die Vorteile der Erfindung gemäß Anspruch 1 zeigen sich nicht nur bei einer Frequenz- bzw. Phasendemodulation des Signals S bzw. Q. Da die relevanten Flanken des Signals S bzw. Q im digitalen Zeitraster des Taktes C liegen, können sie z. B. mit rein digitalen Verfahren gespeichert, verzögert, oder andersartig verarbeitet werden.

Da das Signal S bzw. Q selbst ein Binärsignal ist, welches die Phasen- und Frequenzinformation des Binärsignals B (zuzüglich eines Phasen-Quantisierungsrauschens) enthält, ist das Signal S bzw. Q zu den bekannten analogen Frequenz- bzw. Phasendemodulationsverfahren (z. B. Ratio-Detektor) weitgehend kompatibel und kann mit diesen demoduliert werden.

In der Fig. 1 sind die gesteuerten Quellen $S_1 ... S_n$ symbolhaft durch Umschalter in Verbindung mit Quellen für konstante Größen (z. B. $M_i$ ; $N_i$) dargestellt. Außer durch eine Konfiguration mit Umschaltern lassen sich gesteuerte Quellen auch durch andere Schalterkonfigurationen symbolhaft darstellen, z.B. durch gesteuerte Ein- und Ausschalter, bei denen eventuell Anteile der Größen $M_1$; $N_1 ... M_n$; $N_n$ hinter den Schaltern zugeführt werden. Diese Summationspunkte wiederum können außerhalb der Filter- und Summierschaltung 2 (d. h. dann innerhalb der gesteuerten Quellen) liegen oder auch innerhalb der Filter- und Summierschaltung 2.

Die Entsprechung von Um-, Ein-, und Ausschaltern ist in der Fig. 20 verdeutlicht. Die Fig. 20 A zeigt eine gesteuerte Quelle, dargestellt (wie oben) durch einen gesteuerten Umschalter $S_i$, der eine elektrische Größe zwischen den Werten $M_i$ und $N_i$ hin- und herschaltet. Bei Ansteuerung mit S = 'logisch 1' liefere er den Wert $M_i$, und bei Ansteuerung mit S = 'logisch 0' (Ruhestellung des Umschalters) den Wert $N_i$. Die Fig. 20 B zeigt eine hierzu gesteuerte Quelle mit einem gesteuerten Einschalter $S_i$, dem ein Summationspunkt $\Sigma_i$ folgt. Bei Ansteuerung mit S = 'logisch 0' (Einschalter $S_i$ offen, Ruhestellung) liefert der Summationspunkt den Wert $N_i$, und bei Ansteuerung mit S = 'logisch 1' (Einschalter geschlossen) den Wert $N_i + (M_i - N_i) = M_i$. Die Fig. 20C zeigt eine hierzu äquivalente gesteuerte Quelle mit einem gesteuerten Ausschalter $S_i$, dem ein Summationspunkt $\Sigma_i$ folgt. Bei Ansteuerung mit S = 'logisch 0' (Ausschalter $S_i$ geschlossen, Ruhestellung) liefert der Summationspunkt den Wert $M_i + (N_i - M_i) = N_i$, und bei Ansteuerung mit S = 'logisch 1' (Auschalter offen) den Wert $M_i$.

Die Fig. 20 D zeigt, daß die gezeigten Summationspunkte $\Sigma_i$ auch Teil der Filter- und Summierschaltung 2 sein können.

Als durch Logiksignale gesteuerte Quellen für elektrische Größen eignen sich sowohl gesteuerte Spannungsquellen, als auch gesteuerte Stromquellen. Die Realisierung solcher Quellen kann auf sehr vielfältige Weise erfolgen: Je nach gewähltem Schaltungskonzept und Technologie können dies z. B. Konstantspannungs- oder Konstantstromquellen sein, die kombiniert sind z. B. mit Bipolar-, JFET- oder MOS-Transistor-Schaltern, Schottky-Dioden-Schaltern, oder GaAs-Schaltern. Die Schalter müssen auch nicht den Quellen nachgeschaltet sein, sondern können direkt Bestandteil der Quellen sein, und deren Quellenverhalten (Ausgangsstrom oder Spannung) in Abhängigkeit vom Logiksignal S beeinflussen. Z.B. können vom Signal S angesteuerte Analogmultiplizier als gesteuerte Quellen verwendet werden.

Als sehr einfach zu realisierende gesteuerte Quellen können mitunter direkt die Ausgänge von Logikgattern der Speicher- und Logikschaltung 1 verwendet werden, z. B. das Signal S.

Quantisierer nach dem im Anspruch 1 beschriebenen Verfahren können leicht als diskret aufgebaute Schaltungen realisiert werden, was vor allem während der Schaltungsentwicklung interessant ist. Die Quantisierer eignen sich jedoch wegen ihrer einfachen Topologie und der geringen Ansprüche an Bauteiletoleranzen besonders für die Umsetzung in Hyridtechnik oder in voll-integrierte Schaltungen (ICs), was einerseits Vorteile bei der Quantisierung von Binärsignalen bis in den GHz-Bereich bringt, und andererseits die günstige Herstellung in großen Stückzahlen erlaubt.

Es wird mit der Frequenz des Taktgenerators 5 eine numerische Folge (im folgenden Z genannt) gebildet, deren Folgenelemente zwei vorgegebene Werte annehmen können, wobei die Folgenelemente bei jedem Takt des Taktgenerators 5, in dem die Speicher- und Logikschaltung 1 jeweils in den zweiten Ausgangszustand gesetzt wird, oder hierzu eine feste Anzahl Takte des Taktgenerators 5 verschoben für eine feste Taktanzahl des Taktgenerators 5 den einen vorgegebenen Wert (im folgenden $c_1$ genannt) annehmen, und den anderen Wert (im folgenden $c_0$ genannt) sonst.

Durch diese Ausgestaltung der Erfindung wird die Folge der Takte, in denen die Speicher- und Logikschaltung 1 jeweils in den zweiten Ausgangszustand gesetzt wird, in eine numerische Folge Z im Taktraster des Taktgenerators 5 umgesetzt, welche die Eigenschaft eines digital pulsfrequenz- bzw. pulsphasenmodulierten Signals (sog. PFM-bzw. PPM-Signal) aufweist. Hierbei ist die in der numerischen Folge Z enthaltene PFM bzw. PPM diejenige des Binärsignals B (zuzüglich Quantisierungs-Phasenrauschen).

Die Erzeugung einer solchen numerische Folge ist ein besonders vorteilhafter Zwischenschritt vor einer analogen oder digitalen Weiterverarbeitung bzw. Demodulation.

Die PFM- bzw. PPM-Eigenschaften der numerischen Folge Z können unter anderem durch die Vorgabe der zwei möglichen Werte $c_1$ und $c_0$ beeinflußt werden. Im einfachsten Fall besteht die numerische Folge aus Elementen, die nur die zwei vorgegebenen Werte 'logisch 1' oder 'logisch 0' annehmen können (z. B. $c_1 = 1$, $c_0 = 0$). In diesem Fall ist die numerische Folge Z eine Digitalimpulsfolge mit einer Wortbreite von einem Bit (also ein Bitstrom). Eine solche Digitalimpulsfolge kann auf verschiedene Weise erzeugt werden: Entweder fällt diese als internes Logiksignal in der Speicher- und Logikschaltung 1 bei der Erzeugung des Signals S an (z. B. als Impulsfolge $Q_1$ in der Speicher- und Logikschaltung 1 nach Fig. 5). Oder sie kann leicht durch ein Schaltwerk aus dem von der Speicher- und Logikschaltung 1 gelieferten Signal S bzw. Q erzeugt werden.

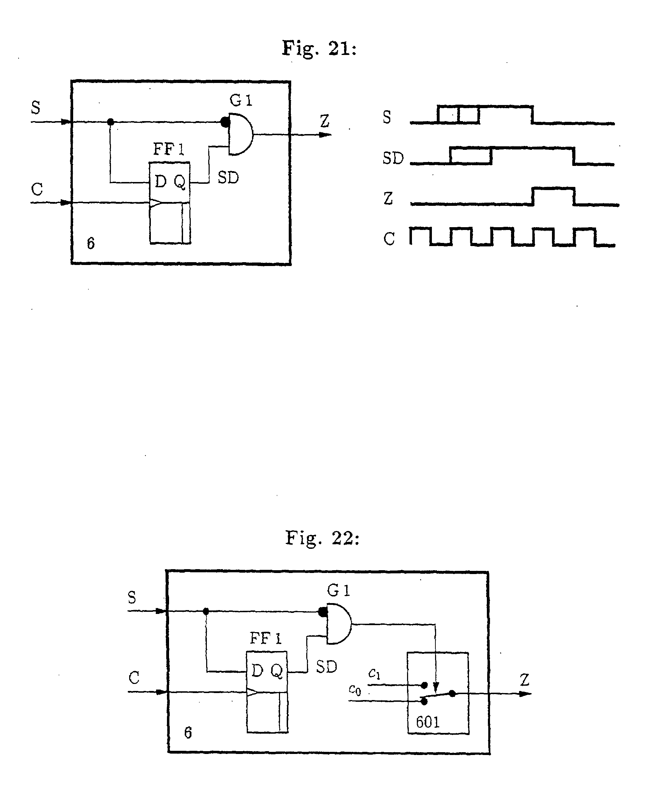

Hierzu zeigt die Fig. 21 als einfaches Beispiel ein vom Taktgenerator 5 getaktetes Schaltwerk aus einem D-Flipflop (FF1) und einem Gatter (G1), welches die fallenden Flanken des Signals S in positive Digitalimpulse Z der Dauer einer Periode des Taktes C umsetzt.

Durch andere Schaltwerke lassen sich aus dem Signal S bzw. Q leicht Digitalimpulsfolgen Z erzeugen, welche gegenüber den Zeitpunkten, zu denen die Speicher- und Logikschaltung 1 jeweils in den zweiten Ausgangszustand gesetzt wird, verschoben sind, oder die eine andere Impulsdauer als die einer Periode des Taktes C aufweisen (z. B. zwei Taktperioden).

Im allgemeinen Fall können die Folgenelemente der numerischen Folge Z zwei vorgegebene Werte $c_1$ und $c_0$ annehmen, die von 'logisch 1' oder 'logisch 0' verschieden sind (z. B. $c_1 = 553$, $c_0 = -107$). Die Erzeugung einer solchen numerischen Folge Z mit $c_1 \neq 1$, $c_0 \neq 0$ kann in sehr ähnlicher Weise erfolgen wie die Erzeugung der vorgenannten Digitalimpulsfolge mit $c_1 = 1$, $c_0 = 0$, indem zusätzlich eine gesteuerte Umschaltlogik zum Umschalten zwischen den Werten $c_1$ und $c_0$ eingeführt wird. Zur Ansteuerung dieser Umschaltlogik kann, falls vorhanden, wieder ein internes Logiksignal in der Speicher- und Logikschaltung 1 verwendet werden, das bei der Erzeugung des Signals S anfällt (z. B. als Impulsfolge $Q_1$ in der Speicher- und Logikschaltung 1 nach Fig. 5). Oder das Signal zum Ansteuern der Umschaltlogik kann leicht durch das gleiche Schaltwerk wie in der Fig. 21 erzeugt werden. Das Beispiel eines entsprechend modifizierten Schaltwerkes mit Umschaltlogik 601 zeigt die Fig. 22. Die Umschaltlogik 601 kann z. B. durch Logikgatter oder digitale Multiplexer realisiert werden.

Amplitudenspektren von PFM- bzw. PPM-Signalen enthalten in der Nähe der Frequenz Null (d. h. im Basisbandbereich der ihnen aufmodulierten Nutzsignale) vor allem Spektralanteile der Nutzsignale selbst. Daher kann durch geeignete Tiefpaßfilterung eines PFM- bzw. PPM-Signals leicht eine Frequenz- bzw. Phasendemodulation erfolgen. Diese Eigenschaft von PFM- bzw. PPM-Signalen kann nutzbringend angewandt werden, um eine Frequenz- bzw. Phasendemodulation der numerischen Folge Z durchzuführen, welche je nach Modulation auch ein PFM- bzw. PPM-Signal ist.

Diese Art der Demodulation kann im Analogbereich erfolgen, indem das PFM- oder PPM-Signal Z, d. h. die numerische Folge Z, welche aus dem Binärsignal B erzeugt wurde, nach Digital/Analog- (D/A-)Umsetzung in eine elektrische Größe einem analogen Tiefpaß zugeführt wird. Diese D/A-Umsetzung wird besonders einfach, wenn die numerische Folge eine Digitalimpulsfolge ($c_1 = 1$, $c_0 = 0$) ist.

Am Ausgang des Tiefpasses erhält man ein analoges Signal, welches das Ergebnis der Frequenz- bzw. Phasendemodulation der numerischen Folge Z, und damit auch des Binärsignals B ist. Eine Demodulation der numerischen Folge Z kann auch durch andere bekannte analoge Demodulationsverfahren (z. B. Ratio-Detektor) erfolgen. Eine analoge Demodulation der numerischen Folge Z weist jedoch Nachteile auf, da das Ausgangssignal eines analogen Demodulators vom thermischen Rauschen seiner analogen Schaltungskomponenten überlagert ist. Ferner ist das Demodulationsergebnis eine analoge Größe, so daß eine A/D-Umsetzung erforderlich ist, falls ein digitales Demodulationsergebnis gewünscht ist.

Des Weiteren wird die numerische Folge Z einer digitalen Tiefpaßfilterung unterzogen, wodurch die Frequenz- bzw. Phaseninformation des Binärsignals B als numerische Ergebnisfolge geliefert wird.

Diese vorteilhafte Ausgestaltung der Erfindung gestattet eine rein digitale Frequenz-bzw. Phasendemodulation des Binärsignals B. Sie basiert auf der genannten Grundlage, daß Amplitudenspektren von PFM- bzw. PPM-Signalen in der Nähe der Frequenz Null vor allem Spektralanteile der aufmodulierten Nutzsignale selbst enthalten, was auch für den Fall digitaler PFM- bzw. PPM-Signale gilt.

Da die numerische Folge Z die Frequenz- bzw. Phaseninformation des Binärsignals B (zuzüglich dem Quantisierungs-Phasenrauschen des Verfahrens nach Anspruch 1) enthält, kann die Frequenz- bzw. Phaseninformation des Binärsignals B d. h. das aufmodulierte Nutzsignal zurückgewonnen werden, indem die numerische Folge Z einem digitalen Tiefpaßfilter zugeführt wird. Der Ausgang dieses Tiefpaßfilters liefert die Frequenz- bzw. Phaseninformation des Binärsignals B als numerische Ergebnisfolge bzw. digitalen Datenstrom, der mit digitalen Verfahren weiterverarbeitet werden kann.

Als Tiefpaßfilter können sowohl rekursive als auch nichtrekursive Digitalfilter (sog. FIR-Filter) eingesetzt werden. Besonders günstig sind hierbei gleitende Mittelwertfilter erster und höherer Ordnung, da sie sehr einfach zu realisieren sind. Der Abtasttakt des Tiefpaßfilters sollte synchron zum Taktraster der numerischen Folge Z sein. Z. B. kann vorteilhaft der Takt C des Taktgenerators 5 als Abtasttakt des Digitalfilters genutzt werden.

Die Gewinnung der quantisierten Frequenz- und Phaseninformation des Binärsignals B durch ein digitales Tiefpaßfilter wird durch folgendes Beispiel veranschaulicht (unter Vernachlässigung des Quantisierungsrauschens):

Das Binärsignal B habe die Frequenz $f_B$; damit treten auch in der numerischen Folge Z die Folgenelemente mit dem Wert $c_1$ mit der Frequenz $f_B$ auf; es sei hierfür angenommen, daß die Elemente der numerischen Folge Z den Wert $c_1$ jeweils für die Dauer nur einer Taktperiode des Taktgenerators 5 annehmen, und sonst den Wert $c_0$. Der Abtasttakt C habe die Frequenz $f_C$. Der Mittelwert $\bar{Z}$ der so gebildeten numerischen Folge Z ist:

$$\overline{Z} = c_1 \cdot \frac{f_B}{f_C} + c_0 \cdot \left(1 - \frac{f_B}{f_C}\right) = c_0 + \frac{f_B}{f_C} \cdot (c_1 - c_0)$$

(z.B. ist bei der Binärsignalfrequenz $f_B = 10{,}7$ MHz und einer Taktfrequenz $f_C = 66$ MHz und mit $c_1 = 1$, $c_0 = 0$ der Mittelwert der numerischen Folge Z gleich $0{,}16\overline{21}$).

Das digitale Tiefpaßfilter habe in seinem niederfrequenten Durchlaßbereich, der im allg. weit unterhalb der Binärsignalfrequenz $f_B$ liege, die (hier vereinfachend als konstant angenommene) Verstärkung $\upsilon_{TP}$. Die numerische Ergebnisfolge am Ausgang des Tiefpaßfilters besteht aus den Werten $\upsilon_{TP} \cdot \bar{Z}$ (evtl. zuzüglich Rundungsfehler), welche proportional zur Frequenz $f_B$ sind. Somit liefert das digitale Tiefpaßfilter an seinem Ausgang die Frequenzinformation des Binärsignals B.

Ist die Frequenz $f_B$ nicht konstant, wenn z.B. das Binärsignal B frequenz- bzw. phasenmoduliert ist, so ist die Grenzfrequenz des Tiefpaßfilters groß genug zu wählen, um das aufmodulierte Nutzsignal durchzulassen. Die Tiefpaßgrenzfrequenz sollte jedoch niedrig genug sein, um einen möglichst großen Anteil des Quantisierungsrauschens zu unterdrücken. Dies entspricht einer Auflösungssteigerung für die am Tiefpaßfilterausgang gelieferte numerische Ergebnisfolge (analog zu der bei $\Delta\Sigma$-A/D-Umsetzern angewandten Auflösungssteigerung durch digitale Tiefpaßfilterung).

Durch geeignete Wahl der vorgegebenen Werte $c_0$ und $c_1$ kann der Wertebereich der numerischen Ergebnisfolge am Ausgang des digitalen Tiefpaßfilters verschoben werden.

Hierdurch kann z. B. erreicht werden, daß bei der Demodulation von Binärsignalen B, die eine Frequenz-bzw. Phasenmodulation bezüglich einer Mittenfrequenz aufweisen, die Ergebnisfolge am Ausgang des Tiefpaßfilters ohne Gleichanteil entsteht, so daß das dem Binärsignal B aufmodulierte Nutzsignal mit Werten um Null herum geliefert wird.

Bsp.: Das Binärsignal B habe die Frequenz $f_B$ = 10,7 MHz, die Taktfrequenz sei $f_C$ = 66 MHz, ferner sei $c_1$ = 553, $c_0$ = -107. Für diese Werte gilt:

$$\bar{Z} = c_0 + \frac{f_B}{f_C} \cdot (c_1 - c_0) = 0$$

Bei einer Frequenzablage von +150 kHz des Binärsignals B, also $f_B$ = 10,85 MHz, ist $\bar{Z}$ = +1,5. Bei einer Frequenzablage von -150 kHz, $f_B$ = 10,55 MHz, ist Z = -1,5. Somit demoduliert das digitale Tiefpaßfilter die numerische Folge Z, die aus dem Binärsignal B mit einem Frequenzhub von ±150kHz durch Quantisierung gebildet wurde, und liefert das Nutzsignal am Filterausgang als Wertefolge mit einem Wertebereich -1,5 ... +1,5.

Eine eventuell gewünschte Verschiebung des Wertebereiches am Ausgang des digitalen Tiefpaßfilters kann auch durch Addition oder Subtraktion einer numerischen Konstanten an einer geeigneten Stelle innerhalb des Tiefpaßfilters oder an seinem Ausgang erreicht werden.

Des Weiteren wird die numerische Folge Z einer digitalen Tiefpaßfilterung mit Abtastratenreduktion unterzogen, wodurch die Frequenz- bzw. Phaseninformation des Binärsignals B als numerische Ergebnisfolge bei reduzierter Abtastrate geliefert wird.

Diese Ausgestaltung der Erfindung ist besonders vorteilhaft anwendbar, wenn die obere Grenzfrequenz des Nutzsignals, welches als Frequenz- bzw. Phasenmodulation im zu quantisierenden Binärsignal B enthalten ist, wesentlich geringer ist als die mittlere Binärsignalfrequenz.

Unter einer Tiefpaßfilterung mit Abtastratenreduktion wird hier der Einsatz sogenannter Dezimationsfilter verstanden. Dies sind digitale Tiefpaßfilter, bei denen die Eingangssignalwerte (hier die numerische Folge Z) mit einer höheren Taktfrequenz abgetastet werden als die am Filterausgang gelieferte numerische Ergebnisfolge. Solchen Dezimationsfiltern können auch weitere Digitalfilter nachgeschaltet sein, z. B. um den Frequenz- bzw. Phasengang günstig zu beeinflussen.

Dezimationsfilter weisen gegenüber digitalen Tiefpaßfiltern mit durchgängig hoher Abtastfrequenz $f_C$, wie z. B. beim Anspruch 5 beschrieben, den Vorteil auf, daß der erforderliche arithmetische Aufwand im allg. stark reduziert ist. Entsprechend einfacher ist die Realisierung eines solchen Dezimationsfilters.

Eine mit besonders geringem Aufwand realisierbare Klasse von Dezimationsfiltern sind die sogenannten Kammfilter mit Abtastratenreduktion. Kammfilter 1. Ordnung sind z.B. FIR-Filter, bei denen alle Koeffizienten gleich sind (z.B. gleich Eins). Die Übertragungsfunktion $H(z)$ eines Kammfilters 1. Ordnung lautet:

$$H(z) = \frac{1 - z^{-D}}{1 - z^{-1}}$$

Hierbei ist $D$ der Dezimationsfaktor, welcher definiert ist als das Verhältnis zwischen der hohen Abtastfrequenz $f_C$ am Filtereingang und der niedrigeren Abtastfrequenz $f_D$ am Filterausgang:

$$D = \frac{f_C}{f_D}$$

Die Hintereinanderschaltung von $n$ Kammfiltern 1. Ordnung ergibt ein Kammfilter n. Ordnung, mit der Übertragungsfunktion:

$$H(z) = \left( \frac{1 - z^{-D}}{1 - z^{-1}} \right)^n$$

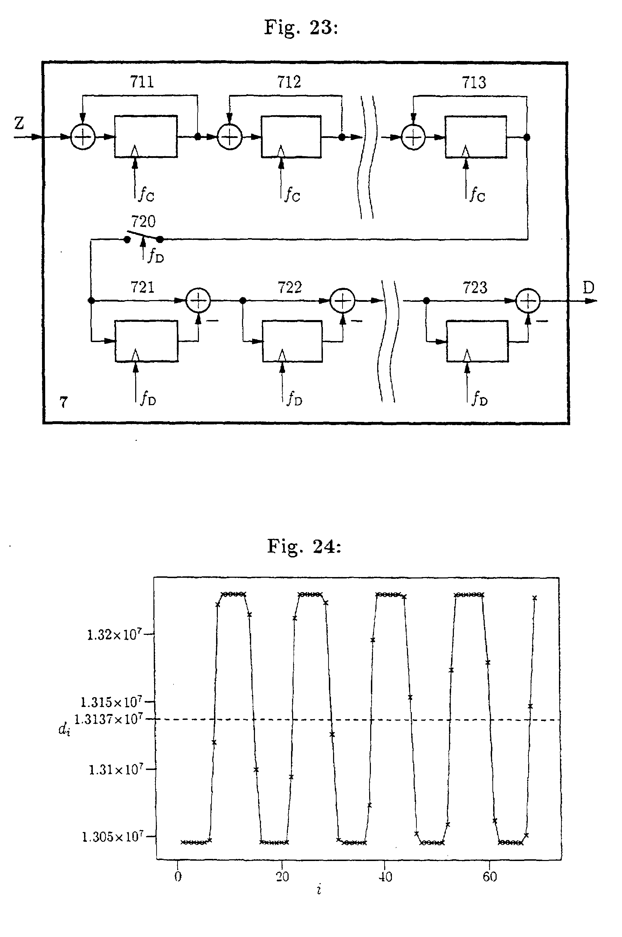

Kammfilter $n$. Ordnung mit Abtastratenreduktion lassen sich besonders leicht durch Hintereinanderschalten von $n$ rückgekoppelten digitalen Akkumulatoren, einem Abtastglied zur Abtastratenreduktion und $n$ digitalen Differenziergliedern realisieren. Als Beispiel hierzu zeigt die Fig. 23 ein Kammfilter 7 $n$. Ordnung. Die $n$ kaskadierten rückgekoppelten Akkumulatoren, von denen drei, 711, 712, und 713 gezeigt sind, werden mit der Frequenz $f_C$ getaktet. Das Abtastglied 720 sowie die $n$ kaskadierten digitalen Differenzierglieder, von denen drei, 721, 722 und 723 gezeigt sind, werden mit der Frequenz $f_D$ getaktet. Die numerische Ergebnisfolge D wird dann mit der Abtastfrequenz $f_D$ geliefert.

Wie von den $\Delta\Sigma$-A/D-Umsetzern bekannt, kann auch beim Quantisierungsverfahren dieser Erfindung die Dezimation in mehren Stufen erfolgen, durch Hintereinanderschaltung von Dezimationsfiltern mit unterschiedlichen Abtastraten und Dezimationsfaktoren.

Das folgende Zahlenbeispiel erläutert die Frequenzdemodulation eines Binärsignals B im genormten FM-Zwischenfrequenzbereich mit Hilfe des Verfahrens aus dieser Erfindung:

Das Binärsignal B habe die Frequenz $f_B$ = 10,7 MHz. Es sei hier wieder angenommen, daß die Folgenelemente der numerischen Folge Z den Wert $c_1$ jeweils für die Dauer nur einer Taktperiode des Taktgenerators 5 annehmen, und sonst den Wert $c_0$; ferner gelte $c_1$ = 1, $c_0$ = 0. Die Frequenz des Taktgenerators 5 sei $f_C$ = 65,664 MHz. Das Dezimationsfilter sei ein Kammfilter 3. Ordnung ($n$ = 3), mit dem Dezimationsfaktor D = 432. Die Abtastfrequenz der numerischen Ergebnisfolge D ist $f_D$ = $f_C$/D = 152 kHz (hier das achtfache der FM-Stereo-Pilottonfrequenz von 19 kHz—diese Wahl der Frequenz $f_D$ gestattet eine besonders günstige Implementation eines eventuell nachgeschalteten volldigitalen Stereo-Decoders). Die Verstärkung eines Kammfilters $n$. Ordnung ist allgemein $\upsilon_{TP}$ = $D^n$, hier also $\upsilon_{TP}$ = 80.621.568.

Die ganzzahlige numerische Ergebnisfolge D am Ausgang des digitalen Kammfilters schwankt um den theoretischen Wert $\upsilon_{TP} \cdot f_B/f_C \approx$ 13.137.347,37 (die Berechnung dieser numerischen Ergebnisfolge D erfordert im Kammfilter eine Arithmetik mit einer Wortbreite von 24 bit).

Stattdessen ergibt ein Binärsignal B mit einer Frequenz $f_B$ = 10,775 MHz (Frequenzablage von 75 kHz gegenüber 10,7 MHz) eine numerische Ergebnisfolge D am Ausgang des Kammfilters, die um den Wert $\upsilon_{TP} \cdot f_B/f_C \approx$ 13.229.230,11 schwankt. Also entspricht einer Frequenzänderung von 75 kHz des Binärsignals B bei den gegebenen Takt- und Filterparametern eine Änderung in der numerischen Ergebnisfolge D von etwa 92.084.

Ein Frequenzhub von ±75 kHz des Binärsignals B wird somit durch das beschriebene Quantisierungsverfahren mit Dezimationsfilter zur Frequenzdemodulation auf einen numerisch voll ausgesteuerten Bereich von ±92.084 der Ergebnisfolge D (Nutzsignal im Basisband) abgebildet. Die Darstellung dieses Nutzsignals erfordert eine Wortbreite von 18 bit.

Die Fig. 24 zeigt das Ergebnis der algorithmischen Simulation eines Quantisierers mit einem Integrator, gemäß dem Hauptanspruch 1 und nach Fig. 2, und mit $M_1$ = -2$N_1$. Gezeigt ist ein Ausschnitt des Zeitverlaufs der numerischen Ergebnisfolge D (Folgenelemente $d_1$) am Ausgang eines Kammfilters 3. Ordnung, das dem Quantisierer nachgeschaltet ist. Es gelten die vorgenannten Parameter, also Taktfrequenz $f_C$ = 65,664 MHz, Dezimationsfaktor $D$ = 432, $c_1$ = 1, $c_0$ = 0. Das dem Quantisierer zugeführte Binärsignal B ist um die Mittenfrequenz $f_0$ = 10.7 MHz herum mit einem Rechtecksignal der Frequenz 10 kHz FSK-moduliert (Frequency-Shift-Keying), und weist einen Frequenzhub von ±75 kHz auf. Man erkennt, daß schon ein Frequenzdemodulator mit nur einem Integrator im Quantisierer Nutzsignale mit sehr guter Signalqualität liefern kann.

Durch geeignete Wahl der vorgegebenen Werte $c_0$ und $c_1$ kann der Wertebereich der numerischen Ergebnisfolge D am Ausgang des Dezimationsfilters verschoben werden, mit entprechender Wirkung wie schon in der Beschreibung des Anspruchs 5 genannt.

Eine eventuell gewünschte Verschiebung des Wertebereiches am Ausgang des digitalen Dezimationsfilters kann auch durch Addition oder Subtraktion einer numerischen Konstanten an einer geeigneten Stelle innerhalb des Dezimationsfilters oder an seinem Ausgang erreicht werden. Die Addition einer Konstanten am Filterausgang hat den Vorteil, daß sie nur mit der niedrigen Abtastfrequenz $f_D$ der Ergebnisfolge D erfolgen muß. Dann ergibt sich eine besonders einfache Struktur des Dezimationsfilters, wenn dessen Eingangsfolge Z nur aus den Werten $c_1$ = 1 und $c_0$ = 0 besteht.

Des Weiteren werden zu der gemäß Anspruch 1-4 durch Quantisierung eines Binärsignals B gebildeten numerischen Folge Z eine oder mehrere weitere numerische Folgen gliedweise addiert (diese werden im folgenden mit dem Buchstaben $Z_1$, $Z_2$, ... gekennzeichnet), und die so gebildete numerische Summenfolge, im folgenden $\tilde{Z}$ genannt, wird anstelle der gemäß Anspruch 1-4 gebildeten numerischen Folge Z weiter genutzt.

Mit weiterer Nutzung ist hier die Übertragung oder Speicherung der Summenfolge $\tilde{Z}$, oder deren analoge oder digitale Verarbeitung, wie z. B. Demodulation gemäß Anspruch 5 bzw. 6 gemeint.

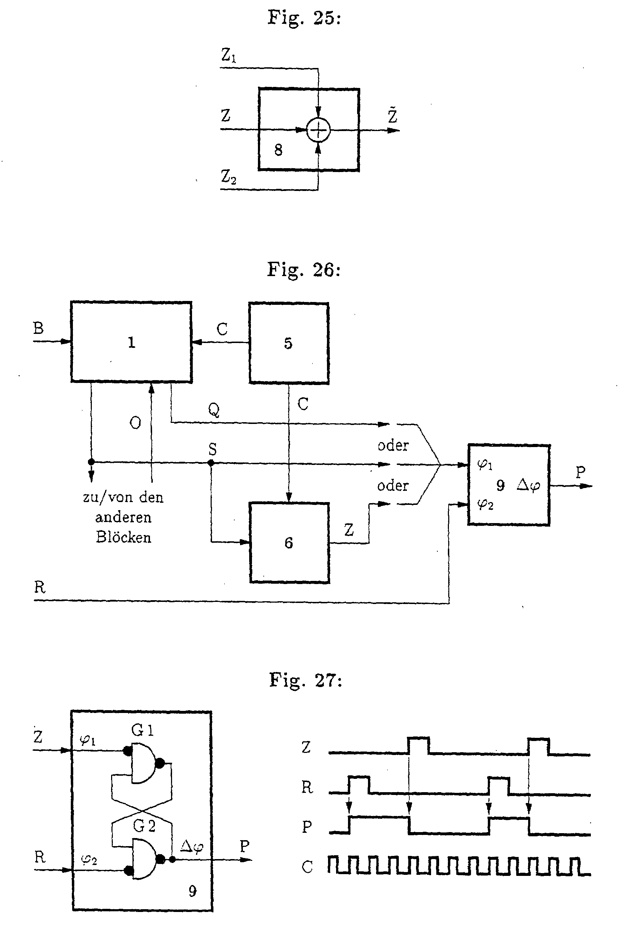

Als Beispiel für eine gliedweise Addition zeigt die Fig. 25 ein digitales Addierglied für die Addition zweier weiterer numerischer Folgen $Z_1$ und $Z_2$ zu einer numerischen Folge Z. Die gliedweise Addition erfolgt synchron zum Takt des Taktgenerators 5, so daß auch die numerische Summenfolge $\tilde{Z}$ mit dem Takt des Taktgenerators 5 entsteht.

Die Addition einer oder mehrerer weiterer numerischer Folgen $Z_1$, $Z_2$, ... zu der numerischen Folge Z, die durch die Quantisierung eines Binärsignals B gemäß Anspruch 1-4 erzeugt wurde, erlaubt eine Beeinflussung der in der numerischen Folge Z enthaltenen Frequenz- bzw. Phaseninformation vor der weiteren Nutzung bzw. Demodulation, vor allem mit Hilfe von Tiefpaß- bzw. Dezimationsfiltern.

Hieraus ergeben sich viele vorteilhafte Anwendungen, z. B. durch Verschiebung der Frequenz: Die numerische Folge Z sei durch Quantisierung des frequenzmodulierten Binärsignals B mit einer Mittenfrequenz $f_0$ entstanden.

Eine (z.B. künstlich erzeugte) numerische Folge $Z_1$ entspreche einem Binärsignal $B_1$ mit einer Frequenz $f_1$. Dann enthält auch die durch gliedweise Addition der Folgen Z und $Z_1$ entstandene Summenfolge $\tilde{z}$ das in der numerischen Folge Z enthaltene FM-Nutzsignal. Eine Demodulation der Summenfolge $\tilde{z}$ mit Hilfe eines Tiefpaß- bzw. Dezimationsfilters gemäß Anspruch 5 bzw. 6 liefert das FM-Nutzsignal jedoch mit einem verschobenen Wertebereich, als wäre es einem Binärsignal mit einer FM-Mittenfrequenz $f_0 + f_1$ aufmoduliert gewesen.

Durch geeignete Wahl der Werte und Vorzeichen der Elemente der numerischen Folge $Z_1$ kann erreicht werden, daß diese Folge einem Binärsignal $B_1$ mit einer negativen Frequenz entspricht. Das in der numerische Summenfolge $\tilde{z}$ enthaltene FM-Nutzsignal erscheint dann nach der Demodulation mit einem Wertebereich, als wäre es einem Binärsignal bei der verschobenen FM-Mittenfrequenz $f_0 + f_1$, welche niedriger als die Frequenz $f_0$ ist. aufmoduliert gewesen.

Stattdessen kann man auch eine numerische Folge $Z_1$, die einem Binärsignal $B_1$ mit einer positiven Frequenz $f_1$ entspricht, gliedweise von der Folge Z subtrahieren, und erhält in diesem Fall eine Differenzfolge $\tilde{z}$ entsprechend einem Binärsignal mit einer FM-Mittenfrequenz $f_0 - f_1$, welche niedriger als die Frequenz $f_0$ ist. Jedoch ist auch diese Differenzbildung nichts anderes als eine Addition gemäß dem Anspruch 7, da Subtraktionen immer in Additionen von Zahlen mit umgekehrten Vorzeichen überführt werden können.

Entspricht die numerische Folge $Z_1$ einem Binärsignal $B_1$ mit einer Frequenz $f_1$ gleich der negativen FM-Mittenfrequenz $f_0$ des Binärsignals B, also $f_1 = -f_0$, so ergibt die gliedweise Summation der Folgen Z und $Z_1$ eine Summenfolge $\tilde{z}$, die das FM-Nutzsignal enthält, als wäre es einem Binärsignal bei der Mittenfrequenz Null aufmoduliert gewesen. Eine anschließende digitale Frequenzdemodulation der Summenfolge $\tilde{z}$, z. B. mit einem digitalen Tiefpaß- bzw. Dezimationsfilter gemäß Anspruch 5 bzw. 6, würde dann das Nutzsignal mit einem Wertebereich um Null herum, also ohne Gleichanteil, liefern.

Bsp.: Im oben gezeigten Beispiel ist bei einer Binärsignalfrequenz $f_B$ = 10,7 MHz und einer Taktfrequenz $f_C$ = 66 MHz und mit $c_1 = 1$, $c_0 = 0$ der Mittelwert der numerischen Folge Z gleich $0,16\overline{21}$. Addiert man hierzu eine weitere numerische Folge $Z_1$ mit dem Mittelwert $-0,16\overline{21}$, so ist der Mittelwert der Summenfolge $\tilde{z}$ bei der Binärsignalfrequenz $f_B$ = 10,7 MHz gleich Null. Eine Variation der Binärsignalfrequenz $f_B$ um die Frequenz 10.7 MHz herum ergibt einen Wertebereich der numerischen Summenfolge $\tilde{z}$, welcher beim Wert Null liegt.

Numerische Folgen mit vorgegebenem Mittelwert, wie z. B. die oben genannte Folge $Z_1$, können leicht mit den von numerisch gesteuerten Oszillatoren (NCO) bekannten Verfahren (z. B. Phasenakkumulationsverfahren mit Auswertung des Überlaufs des höchstwertigen Akkumulator-Bits) synthetisiert werden. Hierbei ist zu beachten, daß die Spektralanteile der zu der numerischen Folge Z addierten numerischen Folgen $Z_1$, $Z_2$, ... die Frequenz- bzw. Phaseninformation des Binärsignal B, z. B. das aufmodulierte Nutzsignal, nicht stören. Daher sollten die Folgen $Z_1$, $Z_2$, ... im allg. nur geringe Spektralanteile im interessierenden Basisband aufweisen.

Die geeignete Auswahl der zur numerischen Folge Z zu addierten numerischen Folge $Z_1$ ergibt mitunter eine besonders einfache Arithmetik in den dem Addierglied evtl. nachgeschalteten Signalverarbeitungsstufen (z. B. Filterung, Demodulation). Besonders vorteilhaft zur zusätzlichen Addition sind numerische Folgen, die aus einfachen, kleinen Zahlen gebildet sind, z. B. aus den Werten -1 und 0: Besteht die numerische Folge Z nur aus Elementen mit den Werten $c_1 = 1$ und $c_0 = 0$, und die hierzu addierte numerische Folge $Z_1$ nur aus Elementen mit den Werten -1 und 0, so fällt das zur Addition der beiden Folgen erforderliche digitale Addierglied besonders einfach aus, da es nur die Wertepaare (0,0), (1,0), (0,-1) und (1,-1) verarbeiten muß, und nur die Ergebnisse -1, 0 und +1 vorkommen können.

Der Trivialfall numerischer Folgen $Z_1$, $Z_2$, ..., die nur aus Elementen mit einem konstanten Wert bestehen, kann ebenfalls zur Addition benutzt werden. Jedoch kann stattdessen dieser Wert mit gleicher Wirkung in die Werte $c_1$ und $c_0$ der numerischen Folge Z eingerechnet werden.

Des Weiteren werden zu einer gemäß Anspruch 1-4 durch Quantisierung eines ersten Binärsignals B gebildeten numerischen Folge eine oder mehrere numerische Folgen gliedweise addiert, von denen eine oder mehrere Folgen jeweils gemäß Anspruch 1-4 durch Quantisierung eines oder weiterer Binärsignale erzeugt wurden, und die so gebildete numerische Summenfolge wird weiter genutzt.

Dieser Anspruch beschreibt einen besonders vorteilhaften Sonderfall des Anspruchs 7, indem eine oder mehrere der numerischen Folgen $Z_1$, $Z_2$, ..., welche zu der numerischen Folge Z addiert werden, ihrerseits durch die Quantisierung weiterer Binärsignale $B_1$, $B_2$, ... mit dem Verfahren gemäß Anspruch 1-4 erzeugt wurden.

Sofern die Binärsignale $B_1$, $B_2$, ... zur gleichen Zeit wie das Binärsignal B zu quantisieren sind, ist hierzu eine entsprechende Anzahl von Quantisierern erforderlich, die jeweils gemäß dem Anspruch 1-4 arbeiten,

Wurde z. B. die numerische Folge Z durch das Verfahren nach Anspruch 1-4 aus einem Binärsignal B mit der Frequenz $f_0$ erzeugt, und eine weitere numerische Folge $Z_1$ ebenfalls durch das Verfahren nach Anspruch 1-4 aus einem weiteren Binärsignal $B_1$ mit der Frequenz $f_1$, so liefert die gliedweise Addition der Folgen Z und $Z_1$ eine numerische Summenfolge $\tilde{z}$ mit folgenden Eigenschaften: Die Summenfolge $\tilde{z}$ enthält die Frequenz-bzw. Phaseninformation eines Binärsignals, dessen Frequenz gleich der Frequenzsumme $f_0 + f_1$ der beiden Binärsignale B und $B_1$ ist.

Durch Wahl der Werte $c_1$ und $c_0$ (siehe Beschreibung zu Anspruch 4) jeweils unabhängig für die Quantisierung der einzelnen Binärsignale B, $B_1$, $B_2$, ... kann erreicht werden, daß die Summenfolge $\tilde{z}$ die Frequenzen $f_0$, $f_1$, $f_2$, ... der

Binärsignale B, B$_1$, B$_2$, ... jeweils in gewichteter Form enthält. Z. B. kann das Summensignal $\tilde{z}$ die Frequenzinformation $\tilde{f}$., mit

$$\frac{\tilde{f}}{f_C} = a + b_0 \frac{f_0}{f_C} + b_1 \frac{f_1}{f_C} + b_2 \frac{f_2}{f_C}$$

enthalten, wobei die Gewichtungsfaktoren $b_0$, $b_1$, $b_2$, ... jeweils durch Wahl der Werte $c_1$ und $c_0$ bestimmt sind, und der konstante Term $\alpha$ sich z.B. durch Addition einer numerischen Folge mit konstanter Frequenzinformation ergibt.

Demoduliert man eine solche Summenfolge $\tilde{z}$ mit Hilfe eines Tiefpaß- bzw. Dezimationsfilters gemäß Anspruch 5 bzw. 6, so erhält man am Filterausgang das in der Summenfolge Z enthaltene Nutzsignal. Dies ist gleich der gewichteten Summe der als FM in den Binärsignalen B, B$_1$, B$_2$, ... enthaltenen Nutzsignale. Man kann auch sagen, daß das Tiefpaß- bzw. Dezimationsfilter an seinem Ausgang die gefilterte gewichtete Summe der Momentanfrequenzen aller Binärsignale B, B$_1$, B$_2$, ... als numerische Ergebnisfolge liefert.

Die beschriebene Vorgehensweise ergibt ein besonders elegantes und genaues Verfahren zur Bestimmung der Frequenzdifferenz zweier Binärsignale B und B$_1$: Zunächst werden die beiden Binärsignale B und B$_1$ durch zwei Quantisierer gemäß dem Verfahren nach Anspruch 1-4 in zwei numerische Folgen Z und Z$_1$ umgesetzt (die Frequenz $f_C$ des Abtasttakt C sei für beide Quantisierer gleich). Die gliedweise Subtraktion der beiden numerischen Folgen Z und Z$_1$ voneinander mit anschließender Tiefpaß- bzw. Dezimationsfilterung der Differenzfolge $\tilde{z}$ liefert am Filterausgang direkt eine zur gefilterten momentanen Differenzfrequenz beider Binärsignale B und B$_1$ proportionale numerische Ergebnisfolge.

Hierbei ist besonders vorteilhaft, daß keines der Binärsignale im Taktraster des Taktgenerators 5 liegen muß, da gleich zu Beginn eine robuste Synchronisierung der Binärsignale durch das Quantisierungsverfahren nach Anspruch 1 erfolgt; die Differenzfrequenz-Information bzw. das sich ergebende Nutzsignal jedoch wird synchron zum Taktraster des Taktgenerators 5 erzeugt, und eignet sich daher hervorragend für die digitale Weiterverarbeitung.

Des Weiteren werden die im Anspruch 7 bzw. 8 gebildete numerische Summenfolge einer digitalen Tiefpaßfilterung ohne oder mit Abtastratenreduktion zugeführt.

Dieser Anspruch betrifft vorteilhafte Ausgestaltungen der Erfindung gemäß Anspruch 1-8, welche bereits bei den Ansprüchen 7 bzw. 8 vorab erläutert wurden. Er erlaubt eine voll-digitale Frequenz- oder Phasendemodulation der genannten Summenfolgen, bzw. die Bestimmung der Frequenzsumme und -differenz mehrerer Binärsignale, welche beliebig asynchron zum Taktraster des Taktgenerators 5 sein können.

Des Weiteren wird die Folge der Zeitpunkte, zu denen die Speicher- und Logikschaltung 1 in den zweiten Ausgangszustand gesetzt wird, oder eine aus diesen Zeitpunkten abgeleitete Digitalimpulsfolge dem einen Eingang eines digitalen Phasenvergleichers zugeführt. Weiterhin wird dem anderen Eingang des Phasenvergleichers ein digitales Vergleichssignal zugeführt. Das Ausgangssignal des Phasenvergleichers wird weiter genutzt.

Mit weiterer Nutzung ist hier die Übertragung oder Speicherung des Phasenvergleicher-Ausgangssignals, oder dessen Verarbeitung gemeint.

Diese vorteilhafte Ausgestaltung des Quantisierungsverfahrens erlaubt eine Digitalisierung der Phasendifferenz zwischen einem Binärsignal B und einem digitalen Vergleichssignal, hier R genannt.

In Verbindung mit einem dem Phasenvergleicher nachgeschalteten digitalen Tiefpaßfilter kann das Verfahren aus dieser Erfindung zu einem digitalen Phasendemodulator erweitert werden, der die Phasendifferenz zwischen einem Binärsignal und einem Vergleichssignal als numerische Ergebnisfolge mit hoher Auflösung liefert.

Zur Erläuterung dient die Fig. 26 (in dieser sind zur Vereinfachung der Darstellung einige Blöcke weggelassen; vergleiche hierzu die Fig. 1). Das Binärsignal B wird der Speicher- und Logikschaltung 1 zugeführt.

Wie beim Anspruch 1-4 beschrieben, wird die Folge der Zeitpunkte, zu denen die Speicher- und Logikschaltung 1 in den zweiten Ausgangszustand gesetzt wird, durch jeweils jede zweite Flanke des Signals S markiert; oder sie ist in einem bei der Erzeugung des Signals S in der Speicher- und Logikschaltung 1 anfallenden internen Logiksignal Q enthalten. Man kann die Folge der Zeitpunkte, zu denen die Speicher- und Logikschaltung 1 in den zweiten Ausgangszustand gesetzt wird, auch mit Hilfe eines Schaltwerks 6 in eine Digitalimpulsfolge Z umsetzen, was z. B. durch das in Fig. 21 gezeigte Schaltwerk erreicht werden kann.

Dem Phasenvergleicher 9 wird an seinem einen Eingang $\varphi_1$ alternativ eines der Signale S, Q, oder Z zugeführt (wenn das Signal Z nicht genutzt wird, ist der Block 6 in der Fig. 26 nicht erforderlich), sein anderer Eingang $\varphi_2$ ist mit dem digitalen Vergleichssignal R verbunden.

Der Phasenvergleicher 9 liefere an seinem Ausgang $\Delta\varphi$ ein Signal P, das ein Maß für die momentane Phasendifferenz zwischen der Folge der Zeitpunkte, zu denen die Speicher- und Logikschaltung 1 in den zweiten Ausgangszustand gesetzt wird, und dem Vergleichssignal R ist. Das Ausgangssignal P kann weiterverarbeitet werden.

Das Referenzsignal R wird vorzugsweise im Taktraster des Taktgenerators 5 erzeugt. z. B. durch Frequenzteilung der Taktfrequenz $f_C$, oder mit Hilfe eines numerisch gesteuerten Oszillators (NCO) mit dem Muttertakt $f_C$. Da auch die relevanten Flanken der Signale S, Q, oder Z im Taktraster des Taktgenerators 5 liegen. liefert der Phasenvergleicher 9 dann im allg. sein Ausgangssignal P ebenfalls im Taktraster des Taktgenerators 5. Daher eignet sich das Signal P besonders gut für die digitale Weiterverarbeitung bzw. Phasendemodulation.

Als Phasenvergleicher 9 können z. B. die von PLL-Anwendungen bekannten pegel- oder flankensensitiven digitalen Phasenvergleicher benutzt werden. Als einfaches Beispiel hierzu zeigt die Fig. 27 links einen Phasenvergleicher 9 aus einem RS-Flipflop, Gatter G1 und G2. Dieser setzt die Phasendifferenz zwischen einer Impulsfolge Z und einem Vergleichssignal R in ein pulsbreitenmoduliertes Signal P um. Die Fig. 27 zeigt rechts den typischen Verlauf der Signale, welche jeweils nur die Zustände 'logisch 0' oder 'logisch 1' annehmen. Man erkennt, daß das Signal P ein pulsbreitenmoduliertes Signal ist, dessen Mittelwert im Wertebereich 0...1 liegt und linear von der Phasenverschiebung zwischen den Signalen R und Z abhängt.

Führt man das Ausgangssignal P einem digitalen Tiefpaß- bzw. Dezimationsfilter zu, so erhält man an dessen Ausgang eine numerische Ergebnisfolge, welche die Phasenverschiebung zwischen den Signalen B und R mit hoher Auflösung liefert. Der beschriebene Aufbau ist daher vorteilhaft als digitaler Phasendemodulator mit digitalem Ergebnisausgang verwendbar.

Das Tiefpaß- bzw. Dezimationsfilter bewirkt außer der Umsetzung des pulsbreitenmodulierten Signals P in die Ergebnisfolge auch, daß das bei der Quantisierung des Binärsignals B durch das Verfahren nach dem Anspruch 1-2 hinzugefügte Quantisierungs-Phasenrauschen weggefiltert wird. Dies entspricht einer Erhöhung der Phasenauflösung in der Ergebnisfolge.

Eine weitere vorteilhafte Anwendung der Erfindung ergibt sich, wenn dem Phasenvergleicher 9 als Vergleichssignal R ein aus der Quantisierung eines zweiten Binärsignals $B_1$ erzeugtes Signal (d. h. alternativ eines der bei der Quantisierung eines zweiten Binärsignals $B_1$ anfallenden Signale $S_1$, $Q_1$, oder $Z_1$) zugeführt wird. Dies erlaubt den digitalen Phasenvergleich zwischen zwei Binärsignalen B und $B_1$, welche beide nicht im Taktraster des Taktgenerators 5 liegen müssen.

Hierzu ist der in der Fig. 26 dem Eingang $\varphi_1$ des Phasenvergleichers 9 vorgeschaltete Quantisierer entsprechend doppelt auszuführen, so daß auch dem Eingang $\varphi_2$ des Phasenvergleichers 9 ein Quantisierer gemäß Anspruch 1-4 vorgeschaltet ist. Entsprechend wird das zweite Binärsignal $B_1$ einer zweiten Speicher- und Logikschaltung zugeführt.

Der Taktgenerator 5 ist vorzugsweise nur einfach auszuführen, wobei beide (Quantisierer mit dem gleichen Takt betrieben werden. Alle Signale S, Q, oder Z bzw. $S_1$, $Q_1$, oder $Z_1$ liegen somit im gleichen Taktraster, und ebenso das Ausgangssignal des Phasenvergleichers 9. Das Ausgangssignal kann zur Demodulation einem digitalen Tiefpaß- bzw. Dezimationsfilter zugeführt werden, so daß mit dem beschriebenen Verfahren eine (kohärente) Phasendemodulation eines ersten Binärsignals bezüglich eines zweiten Referenz-Binärsignals erfolgen kann.

Das Tiefpaß- bzw. Dezimationsfilter filtert in der beschriebenen Anordnung das bei der Quantisierung der beiden Binärsignalen B und $B_1$ hinzugefügte Quantisierungs-Phasenrauschen weg.

Des Weiteren kann das Quantisierungsverfahren nach Anspruch 10 vorteilhaft zur Messung von periodisch wiederkehrenden und variablen Laufzeiten verwendet werden, indem ein aus dem Takt des Taktgenerators durch Frequenzteilung abgeleitetes Testsignal der zu untersuchenden, laufzeitbehafteten Meßstrecke zugeführt wird, und das Binärsignal am Ausgang der Meßstrecke quantisiert wird. Die Phasendifferenz bzw. Laufzeit zwischen dem Testsignal und dem quantisierten Binärsignal kann dann durch einen digitalen Phasenvergleicher mit anschließender digitaler Tiefpaßfilterung ohne oder mit Abtastratenreduktion gebildet werden, wie auch schon im Anspruch 10 beschrieben.

Die Meßstrecke kann z. B. auch eine durch Licht, akustische, oder Radiowellen überbrückte Distanz sein, wobei dann am Anfang und Ende der Meßstrecke geeignete Signalwandler erforderlich sind. Das Ausgangssignal der Meßstrecke ist geeignet aufzubereiten bzw. in ein Binärsignal umzusetzen.

Gewerbliche Anwendbarkeit:

Das beschriebene Verfahren dieser Erfindung kann in vielen Bereichen nutzvoll angewendet werden:

- Bestimmung der Frequenz oder Phase periodischer und quasiperiodischer Signale, z. B. in Frequenz- und Phasenmeßgeräten.

- Digitale Demodulation von frequenz- oder phasenmodulierten Trägersignalen, besonders zur direkten Quantisierung von hochfrequenten FM-Signalen oder der FM-Zwischenfrequenz (ZF), mit voll digitaler Demodulation; z.B. in der Rundfunkempfangstechnik.

- Zur digitalen Demodulation der Empfangs- oder ZF-Signale von Mobiltelefonen und Pagern, als Ersatz für I/Q-Abwärtskonverter oder I/Q-ADCs.

- Zur Demodulation von FSK- (Frequency-Shift-Keying-) oder PSK- (Phase-Shift-Keying-) modulierten Signalen; z. B. in der Kommunikationstechnik.

- Messung von Doppler-Frequenzen bzw. Frequenzverschiebungen. z. B. zur Geschwindigkeitsmessung, bei Radar, Ladar (Laser-Radar), Sonar.

- Messung von periodisch wiederkehrenden Laufzeiten, welche der Phase eines Signals entsprechen, z. B. bei Radar, Ladar, Sonar, bei der (Glasfaser-) Kabellängenmessung.

- Bei phasen- oder laufzeitbasierenden Navigationsverfahren, z. B. DECCA, LO-RAN, OMEGA, TACAN, GPS (Global Positioning System).

- Messung von (auch nicht-elektrischen) Größen, die sich in eine Frequenz oder Phase eines Signals umsetzen lassen, z. B. bei kapazitiven oder induktiven Sensoren, die frequenz- oder phasenbestimmender Teil eines Oszillators sind, z. B. in Beschleunigungssensoren oder Seismometern.

- In HF-Kondensatormikrofonen: Digitalisierung eines vom Schallwandler (d.h. schallempfindlicher, variabler Kondensator als frequenzbestimmender Teil eines HF-Oszillators) frequenzmodulierten Signals, zur direkten Umsetzung des Schalls in ein digitales Audiosignal.

**Patentansprüche**

1. Verfahren zur Quantisierung von Binärsignalen (B); bestehend aus einer digitalen Speicher- und Logikschaltung (1), einer analogen Filter- und Summierschaltung (2) erster oder höherer Ordnung mit einem oder mehreren Eingängen, einer oder mehreren gesteuerten Quellen ($S_1...S_n$) für je eine elektrische Größe mit zwei möglichen Werten ($M_1$; $N_1 ... M_n$; $N_n$), die von Quelle zu Quelle verschieden sein können, einem Komparator (4) mit gegebener Schaltschwelle (L), mit analogem Eingang (F) und Logikausgang (O), sowie einem Taktgenerator (5) mit gegebener Frequenz,

   wobei bei jeder Flanke einer gegebenen Richtung des Binärsignals (B) die Speicher- und Logikschaltung (1) in einen ersten Ausgangzustand gesetzt wird, hierdurch angesteuert die Quelle(n) ($S_1...S_n$) je eine elektrische Größe mit einem ersten konstanten Wert ($M_1....M_n$) liefert/liefern, die Filter- und Summierschaltung (2) diese elektrischen Größe(n) verarbeitet, das Ausgangssignal (F) der Filter- und Summierschaltung (2) während des ersten Ausgangszustandes der Speicher- und Logikschaltung (1) die Schaltschwelle (L) des Komparators (4) durchläuft, worauf dessen Ausgang umschaltet, jeweils beim ersten hierauf folgenden Takt des Taktgenerators oder eine bestimmte Anzahl seiner Takte später die Speicher- und Logikschaltung (1) in einen zweiten Ausgangszustand gesetzt wird, hierdurch angesteuert die Quelle(n) ($S_1 ... S_n$) je eine elektrische Größe mit einem zweiten konstanten Wert ($N_1 ... N_n$) liefert/liefern, die Filter- und Summierschaltung (2) diese elektrischen Größe(n) solange verarbeitet, bis die nächste Flanke gegebener Richtung des Binärsignals (B) eintritt, so daß die Folge der Zeitpunkte, zu denen die Speicher- und Logikschaltung (1) in den zweiten Ausgangszustand gesetzt wird, als digitales Abbild des Binärsignals (B) genutzt wird.

2. Quantisierungsverfahren nach Anspruch 1,
   **dadurch gekennzeichnet, daß** die Folge der Zeitpunkte, zu denen die Speicher- und Logikschaltung (1) in den zweiten Ausgangszustand gesetzt wird, die Frequenz-bzw. Phasenmodulation des Binärsignals (B) aufweist, zuzüglich einer Phasenmodulation durch ein quantisierungsbedingtes Rauschsignal.

3. Quaatisierungsverfahren nach Anspruch 2,
   **dadurch gekennzeichnet, daß** das Leistungsdichtespektrum des quantisierungsbediagten Rauschsignals mit falleader Frequenz abnimmt.

4. Quantisierungsverfahren nach Anspruch 1-3,
   **dadurch gekennzeichnet, daß** mit der Frequenz des Taktgenerators (5) eine numerische Folge gebildet wird, deren Folgenelemenie zwei vorgegebene Werte annehmen können, wobei die Folgenelemente bei jedem Takt des Taktgenerators (5), in dem die Speicher- und Logikschaltung (1) jeweils in den zweiten Ausgangszustand gesetzt wird, oder hierzu eine feste Anzahl Takte des Taktgenerators (5) verschoben für eine feste Taktanzahl des Taktgenerators (5) den einen vorgegebenen Wert annehmen, und den anderen Wert sonst.

5. Quantisietungsverfahren nach Anspruch 1-4.
   **dadurch gekennzeichnet, daß** die numerische Folge einer digitalen Tiefpaßilterung unterzogen wird, wodurch die Frequenz- bzw. Phaseninformation des Binärsignals (B) als numerische Ergebnisfolge geliefert wird.

6. Quantisierungsverfahren nach Anspruch 1-4,
   **dadurch gekennzeichnet, daß** die numerische Folge einer digitalen Tiefpaßfilterung mit Abtastratenreduktion unterzogen wird, wodurch die Frequenz- bzw. Phaseninformation des Binärsignals (B) als numerische Ergebnisfolge bei reduzierter Abtastrate geliefert wird.

7. Quantisierungsverfahren nach Anspruch 1-6,
   **dadurch gekennzeichnet, daß** zu einer gemäß Anspruch 1-4 durch Quantisierung eines Binärsignals gebildeten numerischen Folge eine oder mehrere weitere numerische Folgen gliedweise addiert werden, und die so gebildete numerische Summenfolge anstelle der gemäß Anspruch 1-4 gebildeten numerischen Folge weiter genutzt wird.

8. Quantisierungsverfahren nach Anspruch 1-7,
   **dadurch gekennzeichnet, daß** zu einer gemäß Anspruch 1-4 durch Quantisierung eines ersten Binärsignals gebildeten numerischen Folge eine oder mehrere numerische Folgen gliedweise addiert werden, von denen eine oder mehrere Folgen jeweils gemäß Anspruch 1-4 durch Quantisierung eines oder weiterer Binärsignale erzeugt wurden, und die so gebildete numerische Summenfolge weiter genutzt wird.

9. Quantisierungsverfahren nach Anspruch 1-8,
   **dadurch gekennzeichnet, daß** die im Anspruch 7 bzw. 8 genannte numerische Summenfolge einer digitalen Tiefpaßfilterung ohne oder mit Abtastratenreduktion zugeführt wird.

10. Quantisierungsverfahren nach Anspruch 1-4,
    **dadurch gekennzeichnet, daß** die Folge der Zeitpunkte, zu denen die Speicher- und Logikschaltung (1) in den zweiten Ausgangszustand gesetzt wird, oder eine aus diesen Zeitpunkten abgeleitete Digitalimpulsfolge dem einen Eingang eines digitalen Phasenvergleichers zugeführt wird, weiterhin dem anderen Eingang des Phasenvergleichers ein digitales Vergleichssignal zugeführt wird, und das Ausgangssignal des Phasenvergleichers weiter genutzt wird.

11. Quantisierungsverfahren nach Anspruch 1-10 zur Messung von periodisch wiederkehrenden und variablen Laufzeiten,
    **dadurch gekennzeichnet, daß** ein aus dem Takt des Taktgenerators durch Frequenzteilung abgeleitetes Testsignal einer laufzeitbehafteten Meßstrecke zugeführt wird, das Binärsignal am Ausgang der Meßstrecke gemäß Anspruch 1-4 quantisiert wird, und die Phasendifferenz bzw. Laufzeit zwischen dem Testsignal und dem quantisierten Binärsignal durch einen digitalen Phasenvergleicher mit anschließender digitaler Tiefpaßfilterung ohne oder mit Abtastratenreduktion gebildet wird.

### Claims

1. A process for the quantification of binary signals (B), consisting of a digital storage and logic circuit (1), of an analog filter and summation circuit (2) of the first or higher order with one or more inputs, one or more controlled sources ($S_1 ... S_n$), each for an electric quantity with two possible values ($M_1$; $N_1 ... M_n$; $N_n$), which can be different from one source to another, of a comparator (4) with a given switching threshold (L), with an analog input (F) and a logic output (O), as well as of a clock pulse generator (5) with a given frequency, whereby, for each slope of a given direction of the binary signal (B), the storage and logic circuit (1) is set into a first initial state and, actuated by this, the source(s) ($S_1 ... S_n$) each supplies/supply an electric quantity with a first constant value ($M_1 ... M_n$), the filter and summation circuit (2) processes this/these electrical quantity/quantities, the output signal (F) of the filter and summation circuit (2) passes through the switching threshold (L) of the comparator (4) during the first initial state of the storage and logic circuit (1), whereupon its output switches over, in each case after the next pulse of the clock pulse generator or after a certain number of its pulses, later the storage and logic circuit (1) is set into a second initial state and, actuated by this, the source(s) ($S_1 ... S_n$) each supplies/supply an electric quantity with a second constant value ($N_1 ... N_n$), the filter and summation circuit (2) processes this/these electrical quantity/quantities until the next slope of the given direction of the binary signal (B) occurs, so that the sequence of points in time at which the storage and logic circuit (1) is set into the second initial state is used as the digital image of the binary signal (B).

**2.** The quantification process according to Claim 1,
**characterized in that** the sequence of the points in time at which the storage and logic circuit (1) is set into the second initial state has the frequency or phase modulation of the binary signal (B), in addition to a phase modulation by a quantification noise signal.

**3.** The quantification process according to Claim 2,
**characterized in that** the power density spectrum of the quantification-related noise signal decreases as the frequency drops.

**4.** The quantification process according to Claims 1 through 3,
**characterized in that** the frequency of the clock pulse generator (5) serves to generate a numerical sequence whose sequence elements can assume two prescribed values, whereby, at each pulse of the clock pulse generator (5) in which the storage and logic circuit (1) is set into a second initial state or else a fixed number of pulses of the clock pulse generator (5), shifted for a fixed pulse number of the clock pulse generator (5), the sequence elements assume the one prescribed value and otherwise the other value.

**5.** The quantification process according to Claims 1 through 4,
**characterized in that** the numerical sequence undergoes a digital lowpass filtering, as a result of which the frequency or phase information of the binary signal (B) is supplied as a numerical result sequence.

**6.** The quantification process according to Claims 1 through 4,
**characterized in that** the numerical sequence undergoes a digital lowpass filtering with sampling frequency reduction, as a result of which the frequency or phase information of the binary signal (B) is supplied as a numerical result sequence at a reduced sampling frequency.

**7.** The quantification process according to Claims 1 through 6,
**characterized in that** one or more additional numerical sequences are added incrementally to a numerical sequence generated according to Claim 1 by means of the quantification of a binary signal, and the numerical sum sequence thus generated is further used instead of the numerical sequence generated according to Claims 1 through 4.

**8.** The quantification process according to Claims 1 through 7,
**characterized in that** one or more numerical sequences are added incrementally to a numerical sequence generated according to Claim 1 by means of the quantification of a first binary signal, of which sequences one or more were each generated according to Claims 1 through 4 by means of the quantification of one or more binary signals, and the numerical sum sequence thus generated is further used.

**9.** The quantification process according to Claims 1 through 8,
**characterized in that** the numerical sum sequence referred to in Claim 7 and Claim 8 undergoes a digital lowpass filtering with or without sampling frequency reduction.

**10.** The quantification process according to Claims 1 through 4,
**characterized in that** the sequence of the points in time at which the storage and logic circuit (1) is set into the second initial state, or a digital pulse sequence derived from these points in time is transmitted to the one input of a digital phase comparator, moreover, a digital comparison signal is transmitted to the other input of the phase comparator, and the output signal of the phase comparator is further used.

**11.** The quantification process according to Claims 1 through 10 for the measurement of periodically recurring and variable delays,
**characterized in that** a test signal derived from the pulse of the clock pulse generator by means of frequency division is transmitted to a delay-related measuring section, the binary signal is quantified at the output of the measuring section according to Claims 1 through 4, and the phase difference or delay between the test signal and the quantified binary signal is generated by a digital phase comparator with subsequent digital low-pass filtering or with sampling frequency reduction.

**EP 1 058 966 B1**

**Revendications**

1. Procédé de quantification de signaux binaires (B) comportant un circuit logique numérique à mémoire (1), un circuit filtrant et totalisateur analogique (2) de premier ordre ou d'ordre supérieur avec une ou plusieurs entrées, une ou plusieurs sources commandées ($S_1...S_n$), dont chacune pour une grandeur électrique avec deux valeurs possibles ($M_1$; $N_1...M_n$; $N_n$) pouvant varier d'une source à l'autre, un comparateur (4) avec un seuil de commutation donné (L) avec entrée analogique (F) et sortie logique (O) ainsi qu'un générateur de rythme (5) de fréquence donnée, procédé dans lequel, à chaque flanc de sens donné du signal binaire (B), le circuit logique à mémoire (1) est mis dans un premier état initial, la (les) source(s) ($S_1...S_n$) qui sont activées de ce fait, fournissant chacune une grandeur électrique d'une première valeur constante ($M_1...M_n$), le circuit filtrant et totalisateur (2) traitant cette (ces) grandeur(s) électrique(s), le signal de sortie (F) du circuit filtrant et totalisateur (2) parcourant, lors du premier état initial du circuit logique à mémoire (1), le seuil de commutation (L) du comparateur (4), sur quoi l'entrée de ce dernier commute, et dans lequel, à chaque première cadence subséquente du générateur de rythme ou après un certain nombre de cadences, le circuit logique à mémoire (1) est mis dans un deuxième état initial, la (les) source(s) ($S_1...S_n$) qui sont activées de ce fait, fournissant chacune une grandeur électrique d'une deuxième valeur constante ($N_i...N_n$), le circuit filtrant et totalisateur (2) traitant cette (ces) grandeur(s) électrique(s) jusqu'à ce que le prochain flanc de sens donné du signal binaire (B) survienne, si bien que la séquence des instants, auxquels le circuit logique à mémoire (1) est mis dans le deuxième état initial, soit utilisée comme image numérique du signal binaire (B).

2. Procédé de quantification selon la revendication 1,
   **caractérisé en ce que** la séquence des instants, auxquels le circuit logique à mémoire (1) est mis dans le deuxième état initial, présente la modulation de fréquence ou de phase du signal binaire (B), en plus d'une modulation de phase due au signal de bruit engendré par la quantification.

3. Procédé de quantification selon la revendication 2,
   **caractérisé en ce que** plus la fréquence décroît, plus le spectre de puissance volumique du signal de bruit dû à la quantification diminue.

4. Procédé de quantification selon l'une quelconque des revendications 1 à 3,
   **caractérisé en ce qu'**une séquence numérique est formée à partir de la fréquence du générateur de rythme (5), dont les éléments de séquence peuvent assumer deux valeurs prédéterminées, les éléments de séquence, à chaque cadence du générateur de rythme (5), dans laquelle le circuit logique à mémoire (1) est mis dans le deuxième état initial ou un nombre fixe de cadences du générateur de rythme (5) décalé pour un nombre fixe de cadences du générateur de rythme (5) assumant l'une des valeurs prédéterminées et, par défaut, l'autre.

5. Procédé de quantification selon l'une quelconque des revendications 1 à 4,
   **caractérisé en ce que** la séquence numérique est soumise à un filtrage passe-bas, ce qui a pour conséquence que l'information de fréquence ou de phase du signal binaire (B) est fournie en tant que séquence numérique de résultats.

6. Procédé de quantification selon l'une quelconque des revendications 1 à 4,
   **caractérisé en ce que** la séquence numérique est soumise à un filtrage passe-bas avec réduction du taux d'exploration, ce qui a pour conséquence que l'information de fréquence ou de phase du signal binaire (B) est fournie en tant que séquence numérique de résultats à un taux d'exploration réduit.

7. Procédé de quantification selon l'une quelconque des revendications 1 à 6,
   **caractérisé en ce qu'**une ou plusieurs séquences numériques supplémentaires sont additionnées élément par élément à une séquence numérique formée par quantification d'un signal binaire conformément aux revendications 1 à 4, et qu'on utilise par la suite la séquence des totaux numérique ainsi formée au lieu de la séquence numérique formée conformément aux revendications 1 à 4.

8. Procédé de quantification selon l'une quelconque des revendications 1 à 7,
   **caractérisé en ce qu'**on additionne à une séquence numérique formée conformément aux revendications 1 à 4 par quantification d'un premier signal binaire, une ou plusieurs séquences numériques élément par élément, dont une ou plusieurs séquences ont été engendrées conformément aux revendications 1 à 4 par quantification d'un autre ou d'autres signaux binaires, et qu'on utilise par la suite la séquence de totaux numérique ainsi formée.

9. Procédé de quantification selon l'une quelconque des revendications 1 à 8,
**caractérisé en ce que** la séquence de totaux numérique mentionnée dans les revendications 7 et 8 respectivement est soumise à un filtrage passe-bas sans ou avec réduction du taux d'exploration.

10. Procédé de quantification selon l'une quelconque des revendications 1 à 4,
**caractérisé en ce que** la séquence des instants auxquels le circuit logique à mémoire (1) est mis dans le deuxième état initial, ou une séquence d'impulsions numériques dérivée de ces instants, est amenée à l'une des entrées d'un comparateur de phase numérique, qu'un signal de comparaison numérique est amené à l'autre entrée du comparateur de phase et que le signal de sortie du comparateur de phase et utilisé par la suite.

11. Procédé de quantification selon l'une quelconque des revendications 1 à 10 pour la mesure de temps de propagation récurrent périodiquement et variables,
**caractérisé en ce qu'**un signal d'essai dérivé par division de fréquence de la cadence du générateur de rythme est amené à une section de mesure rapportée au temps de propagation, que le signal binaire est quantifié à la sortie de la section de mesure conformément aux revendications 1 à 4, et que la différence de phase ou le temps de propagation entre le signal d'essai et le signal binaire quantifié est formé par un comparateur de phase numérique avec filtrage passe-bas subséquent sans ou avec réduction du taux d'exploration.

Fig. 1:

Fig. 2:

Fig. 3:

Fig. 4:

Fig. 5:

Fig. 6:

Fig. 7:

Fig. 8:

Fig. 9:

Fig. 10:

Fig. 11:

Fig. 12:

Fig. 13:

Fig. 14:

Fig. 15:

Fig. 16:

Fig. 17:

Fig. 18:

Fig. 19:

Fig. 20:

A                    B                    C                    D

Fig. 21:

Fig. 22:

Fig. 23:

Fig. 24:

Fig. 25:

Fig. 26:

Fig. 27: